# EUROPEAN PATENT APPLICATION

(11) **EP 4 719 012 A1**
(43) Date of publication of application: **01.04.2026**
(21) Application number: 23934855.0
(22) Date of filing: 31.08.2023
(51) Int. Cl.: H10K 59/12

(54) **DISPLAY SUBSTRATE AND MANUFACTURING METHOD THEREFOR, AND DISPLAY DEVICE**

(30) Priority: 28.04.2023 WO PCT/CN2023/091560
(71) Applicant: Boe Technology Group Co., Ltd., Beijing 100015 (CN); Hefei BOE Joint Technology Co., Ltd., Hefei, Anhui 230012 (CN); Beijing BOE Technology Development Co., Ltd., Daxing District Beijing 100176 (CN)
(72) Inventor: DING, Luke, Beijing 100176 (CN); FANG, Jingang, Beijing 100176 (CN); YUAN, Can, Beijing 100176 (CN); YUAN, Zhidong, Beijing 100176 (CN); LIU, Xiuting, Beijing 100176 (CN); LI, Yongqian, Beijing 100176 (CN)
(74) Representative: CMS Cameron McKenna Nabarro Olswang LLP
(86) International application number: PCT/CN2023/116024
(87) International publication number: WO 2024/221686

(57) **Abstract**

A display substrate and a manufacturing method therefor, and a display device. The display substrate comprises a plurality of repeating units (100); each repeating unit (100) comprises a plurality of sub-pixels; each sub-pixel at least comprises a pixel driving circuit, a scanning signal line (30), and an auxiliary signal line (30A); each pixel driving circuit comprises a first electrode sheet (61) and at least one transistor; and the at least one transistor is connected to the first electrode sheet (61) by means of a connecting electrode. In a direction perpendicular to the display substrate, the display substrate comprises a first conductive layer and a second conductive layer, the auxiliary signal lines (30A) and the first electrode sheets (61) are arranged in the first conductive layer, the scanning signal lines (30) and the connecting electrodes are arranged in the second conductive layer, the orthographic projections of the scanning signal lines (30) on a base plane are located within the range of the orthographic projections of the auxiliary signal lines (30A) on the base plane, and the scanning signal lines (30) are in lap joint with the auxiliary signal lines (30A).

## Description

The present application claims priority to PCT Application No. PCT/CN2023/091560, filed on April 28, 2023 and entitled "Display Substrate and Manufacturing Method Therefor, and Display Device", contents of which should be construed as being incorporated herein by reference.

### Technical Field

The present disclosure relates to, but is not limited to, the field of display technologies, in particular to a display substrate, a preparation method therefor, and a display apparatus.

### Background

An Organic Light Emitting Diode (OLED) and a Quantum dot Light Emitting Diode (QLED) are active light emitting display devices and have advantages such as self-luminescence, a wide viewing angle, a high contrast ratio, low power consumption, an extremely high response speed, lightness and thinness, flexibility, and a low cost. With continuous development of display technologies, a display apparatus in which an OLED or a QLED is used as a light emitting device and a Thin Film Transistor (TFT) is used for signal control has become a mainstream product in the field of display at present.

### Summary

The following is a summary of subject matters described herein in detail. The summary is not intended to limit the scope of protection of claims.

In one aspect, a display substrate is provided in the present disclosure, which includes a plurality of repetitive units, at least one of the repetitive units includes a plurality of sub-pixels forming at least two pixel rows and at least two pixel columns, at least one of the sub-pixels includes a pixel drive circuit, a scan signal line configured to provide a scan signal to the pixel drive circuit, and an auxiliary signal line. The pixel drive circuit includes a storage capacitor and at least one transistor, wherein the storage capacitor at least includes a first electrode plate, and the at least one transistor is connected with the first electrode plate through a connection electrode. In a direction perpendicular to the display substrate, the display substrate includes a first conductive layer disposed on a base substrate, and a second conductive layer disposed on a side of the first conductive layer away from the base substrate, the auxiliary signal line and the first electrode plate are disposed in the first conductive layer, the scan signal line and the connection electrode are disposed in the second conductive layer, an orthographic projection of the scan signal line on a plane of the base substrate is within a range of an orthographic projection of the auxiliary signal line on the plane of the base substrate, and the scan signal line is lapped with the auxiliary signal line.

In an exemplary implementation mode, the storage capacitor further includes a second electrode plate, and an orthographic projection of the second electrode plate on the plane of the base substrate is at least partially overlapped with an orthographic projection of the first electrode plate on the plane of the base substrate. The at least one transistor includes a second transistor, the second transistor at least includes a second gate electrode that is connected with the second electrode plate through an electrode plate via, and an orthographic projection of the second gate electrode on the plane of the base substrate contains an orthographic projection of the electrode plate via on the plane of the base substrate.

In an exemplary implementation mode, the second transistor further includes a second active layer, a first region of the second active layer is connected with a first power line via a power supply via, a second region of the second active layer is connected with the first electrode plate through a connection electrode, the first power line is configured to provide a power supply signal to the pixel drive circuit, and an orthographic projection of the first power line on the plane of the base substrate contains an orthographic projection of the power supply via on the plane of the base substrate.

In an exemplary implementation mode, second active layers of two adjacent sub-pixels in two adjacent repetitive units in a pixel row direction are of an interconnected integral structure, and/or, second active layers of two adjacent sub-pixels in two adjacent repetitive units in a pixel column direction are of an interconnected integral structure.

In an exemplary implementation mode, two adjacent sub-pixels in two adjacent repetitive units in a pixel row direction share the power supply via, and/or, two adjacent sub-pixels in two adjacent repetitive units in a pixel column direction share the power supply via.

In an exemplary implementation mode, the connection electrode includes a first connection electrode connected with the first electrode plate, and a third connection electrode lapped with the first connection electrode; the pixel drive circuit further includes a fifth connection electrode which is simultaneously connected with the second region of the second active layer and the third connection electrode through a first lap via; wherein a first dimension of the first lap via is greater than a second dimension of the first lap via, the first dimension is a dimension of the first lap via in a pixel row direction, and the second dimension is a dimension of the first lap via in a pixel column direction.

In an exemplary implementation mode, the power supply via and the first lap via are not on a straight line extending along the pixel row direction.

In an exemplary implementation mode, in the pixel column direction, the power supply via shared by two adjacent sub-pixels in two adjacent repetitive units is located between two adjacent first lap vias in two adjacent repetitive units.

In an exemplary implementation mode, the at least one transistor includes a third transistor, the third transistor at least includes a third active layer, a first region of the third active layer is connected with a compensation signal line through a compensation via, a second region of the third active layer is connected with the first electrode plate through a connection electrode, the compensation signal line is configured to provide a compensation signal to the pixel drive circuit, and an orthographic projection of the compensation signal line on the plane of the base substrate contains an orthographic projection of the compensation via on the plane of the base substrate.

In an exemplary implementation mode, in at least one repetitive unit, third active layers of two adjacent sub-pixels in a pixel row direction are of an interconnected integral structure, and/or, third active layers of two adjacent sub-pixels in a pixel column direction are of an interconnected integral structure.

In an exemplary implementation mode, in at least one repetitive unit, two adjacent sub-pixels in a pixel row direction share the compensation via, and/or, two adjacent sub-pixels in a pixel column direction share the compensation via.

In an exemplary implementation mode, the connection electrode includes a second connection electrode connected with the first electrode plate, and a fourth connection electrode lapped with the second connection electrode; the pixel drive circuit further includes a sixth connection electrode which is simultaneously connected with the second region of the third active layer and the fourth connection electrode through a second lap via; wherein a third dimension of the second lap via is greater than a fourth dimension of the second lap via, the third dimension is a dimension of the second lap via in a pixel row direction, and the fourth dimension is a dimension of the second lap via in a pixel column direction.

In an exemplary implementation mode, the pixel drive circuit further includes a first transistor, the first transistor at least includes a first active layer, a first region of the first active layer is connected with a data signal line through a data via, the data signal line is configured to provide a data signal to the pixel drive circuit, and an orthographic projection of the data signal line on the plane of the base substrate contains an orthographic projection of the data via on the plane of the base substrate.

In an exemplary implementation mode, the pixel drive circuit at least includes a first transistor and a third transistor, wherein the first transistor at least includes a first gate electrode, the third transistor at least includes a third gate electrode, and the first gate electrode and the third gate electrode are connected with the scan signal line through a gate connection electrode, respectively.

In an exemplary implementation mode, in at least one repetitive unit, gate connection electrodes, first gate electrodes, and third gate electrodes of two adjacent sub-pixels in a pixel column direction are disposed in a same layer, and are of an interconnected integral structure.

In an exemplary implementation mode, an orthographic projection of the gate connection electrode on the plane of the base substrate is at least partially overlapped with an orthographic projection of the scan signal line on the plane of the base substrate, and the gate connection electrode is connected with the scan signal line through a gate connection via.

In an exemplary implementation mode, in at least one repetitive unit, two adjacent sub-pixels in a pixel column direction share the gate connection electrode.

In an exemplary implementation mode, in at least one repetitive unit, two adjacent sub-pixels in a pixel column direction share the gate connection via.

In another aspect, a display apparatus is also provided in the present disclosure, which includes the aforementioned display substrate.

In yet another aspect, a preparation method of a display substrate is also provided in the present disclosure, wherein the display substrate includes a plurality of repetitive units, at least one of the repetitive units includes a plurality of sub-pixels forming at least two pixel rows and at least two pixel columns, at least one of the sub-pixels includes a pixel drive circuit, a scan signal line configured to provide a scan signal to the pixel drive circuit, and an auxiliary signal line; the pixel drive circuit includes a storage capacitor and at least one transistor, wherein the storage capacitor at least includes a first electrode plate, and the at least one transistor is connected with the first electrode plate through a connection electrode; the preparation method includes: forming a first conductive layer on a base substrate, and a second conductive layer disposed on a side of the first conductive layer away from the base substrate, wherein the auxiliary signal line and the first electrode plate are disposed in the first conductive layer, the scan signal line and the connection electrode are disposed in the second conductive layer, an orthographic projection of the scan signal line on a plane of the base substrate is within a range of an orthographic projection of the auxiliary signal line on the plane of the base substrate, and the scan signal line is lapped with the auxiliary signal line.

In an exemplary implementation mode, the forming the first conductive layer on the base substrate and the second conductive layer disposed on the side of the first conductive layer away from the base substrate, includes: depositing a first conductive thin film and a second conductive thin film sequentially; and using a patterning process with a half-tone mask to form the scan signal line and the auxiliary signal line through a first-time etching process, and to form the first electrode plate and the connection electrode through a second-time etching process.

In an exemplary implementation mode, the storage capacitor further includes a second electrode plate, and an orthographic projection of the second electrode plate on the plane of the base substrate is at least partially overlapped with an orthographic projection of the first electrode plate on the plane of the base substrate. The preparation method further includes: depositing a semiconductor thin film on a side of the second conductive layer away from the base substrate; and using a patterning process with a half-tone mask to form the second electrode plate through an etching process and a conductorization treatment process sequentially.

Other aspects may be comprehended upon reading and understanding drawings and detailed description.

### Brief Description of Drawings

Accompanying drawings are intended to provide further understanding of technical solutions of the present disclosure and constitute a part of the specification, and are used for explaining the technical solutions of the present disclosure together with embodiments of the present disclosure, but do not constitute limitations on the technical solutions of the present disclosure. Shapes and sizes of various components in the drawings do not reflect actual scales, but are only intended to schematically illustrate contents of the present disclosure.
FIG. 1 is a schematic diagram of a structure of a display apparatus.
FIG. 2 is a schematic diagram of a planar structure of a display substrate according to an exemplary embodiment of the present disclosure.
FIG. 3 is an equivalent circuit diagram of a pixel drive circuit in a repetitive unit according to an exemplary embodiment of the present disclosure.
FIG. 4 is a schematic diagram of a structure of a display substrate according to an exemplary embodiment of the present disclosure.
FIGs. 5A to 5D are schematic diagrams of a display substrate after formation of patterns of a first conductive layer and a second conductive layer according to the present disclosure.
FIGs. 6A to 6C are schematic diagrams of a display substrate after formation of a pattern of a semiconductor layer according to the present disclosure.
FIGs. 7A and 7B are schematic diagrams of a display substrate after formation of a pattern of a second insulation layer according to the present disclosure.
FIGs. 8A to 8C are schematic diagrams of a display substrate after formation of a pattern of a third conductive layer according to the present disclosure.
FIG. 9 is a schematic diagram of a display substrate after formation of patterns of a third insulation layer and a planarization layer according to the present disclosure.
FIGs. 10A and 10B are schematic diagrams of a display substrate after formation of a pattern of a fourth conductive layer according to the present disclosure.
FIG. 11 is a schematic diagram of a display substrate after formation of a pattern of a pixel definition layer according to the present disclosure.

Reference numbers are described as follows.

| | | | | | |
|---|---|---|---|---|---|
| 10- | base substrate; | 11- | first connection electrode; | 12- | second connection electrode; |
| 13- | third connection electrode; | 14- | fourth connection electrode; | 15- | fifth connection electrode; |
| 16- | sixth connection electrode; | 21- | first active layer; | 22- | second active layer; |
| 23- | third active layer; | 30- | scan signal line | 30A- | auxiliary signal line; |
| 31- | first gate electrode; | 32- | second gate electrode; | 33- | third gate electrode; |
| 34- | gate connection electrode; | 51- | first power line; | 52- | data signal line; |
| 53- | compensation signal line; | 60- | storage capacitor; | 61- | first electrode plate; |
| 62- | second electrode plate; | 63- | first electrode; | 64- | anode connection electrode; |
| 71- | first insulation layer; | 72- | second insulation layer; | 100- | repetitive unit. |

### Detailed Description

To make objectives, the technical solutions, and advantages of the present disclosure clearer, the embodiments of the present disclosure will be described in detail below in combination with the accompany drawings. Implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements with reference to the drawings, not to indicate or imply that a referred apparatus or element must have a specific orientation and be structured and operated with the specific orientation, but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or electrical connection; it may be a direct connection, or an indirect connection through an intermediate, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected together through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, and deformation, etc.

In the present disclosure, "about" refers to that a boundary is not defined so strictly and numerical values within a range of process and measurement errors are allowed.

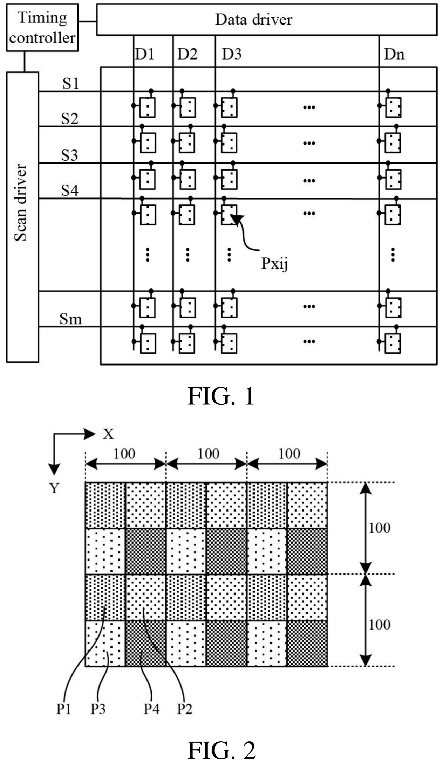

FIG. 1 is a schematic diagram of a structure of a display apparatus. As shown in FIG. 1, an OLED display apparatus may include a timing controller, a data driver, a scan driver, and a pixel array. The timing controller is connected with the data driver and the scan driver respectively, the data driver is connected with a plurality of data signal lines (D1 to Dn) respectively, and the scan driver is connected with a plurality of scan signal lines (S1 to Sm) respectively. The pixel array may include a plurality of sub-pixels Pxij. Each of the sub-pixel Pxij may be connected to a corresponding data signal line and a corresponding scan signal line, wherein i and j may be natural numbers. At least one of the sub-pixels Pxij may at least include a circuit unit and a display unit, wherein the circuit unit may at least include a pixel drive circuit connected with a scan signal line and a data signal line respectively, the display unit may at least include a light emitting device connected with the pixel drive circuit of the circuit unit, and the sub-pixel Pxij may refer to a sub-pixel whose pixel drive circuit is connected to an i-th scan signal line and a j-th data signal line. In an exemplary implementation mode, the timing controller may provide a control signal and a gray-scale value suitable for a specification of the data driver to the data driver, and may provide a scan start signal, a clock signal, and the like suitable for a specification of the scan driver to the scan driver. The data driver may generate a data voltage to be provided to the data signal lines D1, D2, D3, ..., and Dn using the gray-scale value and the control signal that are received from the timing controller. For example, the data driver may sample the gray-scale value using the clock signal and apply a data voltage corresponding to the gray-scale value to the data signal lines D1 to Dn by taking a pixel row as a unit, wherein n may be a natural number. The scan driver may generate a scan signal to be provided to the scan signal lines S1, S2, S3, ..., and Sm by receiving the clock signal, the scan start signal, and the like from the timing controller. For example, the scan driver may provide a scan signal with an on-level pulse to the scan signal lines S1 to Sm sequentially. For example, the scan driver may be constructed in a form of a shift register, and may generate a scan signal in a manner of sequentially transmitting a scan start signal, provided in a form of an on-level pulse, to a next-stage circuit under control of a clock signal, wherein m may be a natural number. In an exemplary implementation mode, the pixel array may be disposed on a display substrate.

An exemplary embodiment of the present disclosure provides a display substrate, which includes a plurality of repetitive units, at least one of the repetitive units includes a plurality of sub-pixels forming at least two pixel rows and at least two pixel columns, at least one of the sub-pixels includes a pixel drive circuit, a scan signal line configured to provide a scan signal to the pixel drive circuit, and an auxiliary signal line. The pixel drive circuit includes a storage capacitor and at least one transistor, wherein the storage capacitor at least includes a first electrode plate, and the at least one transistor is connected with the first electrode plate through a connection electrode. In a direction perpendicular to the display substrate, the display substrate includes a first conductive layer disposed on a base substrate, and a second conductive layer disposed on a side of the first conductive layer away from the base substrate, the auxiliary signal line and the first electrode plate are disposed in the first conductive layer, the scan signal line and the connection electrode are disposed in the second conductive layer, an orthographic projection of the scan signal line on a plane of the base substrate is within a range of an orthographic projection of the auxiliary signal line on the plane of the base substrate, and the scan signal line is lapped with the auxiliary signal line.

In an exemplary implementation mode, the storage capacitor further includes a second electrode plate, and an orthographic projection of the second electrode plate on the plane of the base substrate is at least partially overlapped with an orthographic projection of the first electrode plate on the plane of the base substrate. The at least one transistor includes a second transistor, the second transistor at least includes a second gate electrode, the second gate electrode is connected with the second electrode plate through an electrode plate via, and an orthographic projection of the second gate electrode on the plane of the base substrate contains an orthographic projection of the electrode plate via on the plane of the base substrate.

In an exemplary implementation mode, the second transistor further includes a second active layer, a first region of the second active layer is connected with a first power line through a power supply via, the first power line is configured to provide a power supply signal to the pixel drive circuit, and an orthographic projection of the first power line on the plane of the base substrate contains an orthographic projection of the power supply via on the plane of the base substrate.

In an exemplary implementation mode, the at least one transistor includes a first transistor and a third transistor, wherein the first transistor at least includes a first gate electrode, the third transistor at least includes a third gate electrode, the first gate electrode and the third gate electrode are connected with the scan signal line through a gate connection electrode, respectively.

In an exemplary implementation mode, the first transistor further includes a first active layer, a first region of the first active layer is connected, through a data via, with a data signal line, the data signal line is configured to provide a data signal to the pixel drive circuit, and an orthographic projection of the data signal line on the plane of the base substrate contains an orthographic projection of the data via on the plane of the base substrate.

In an exemplary implementation mode, the third transistor further includes a third active layer, a first region of the third active layer is connected, through a compensation via, with a compensation signal line, the compensation signal line is configured to provide a compensation signal to the pixel drive circuit, and an orthographic projection of the compensation signal line on the plane of the base substrate contains an orthographic projection of the compensation via on the plane of the base substrate.

The display substrate of the present disclosure will be illustrated below through some exemplary embodiments.

FIG. 2 is a schematic diagram of a planar structure of a display substrate according to an exemplary embodiment of the present disclosure. As shown in FIG. 2, in an exemplary implementation mode, a display substrate may include a plurality of repetitive units 100 in a direction parallel to the display substrate, and at least one of the repetitive units 100 may include a plurality of sub-pixels forming at least two pixel rows and at least two pixel columns. In an exemplary implementation mode, repetitive units are basic units constituting the display substrate, and the display substrate is constituted by repetitively and continuously disposing the repetitive units along at least one direction, i.e., the display substrate is formed by splicing the plurality of repetitive units.

In an exemplary implementation mode, one repetitive unit 100 may include four sub-pixels, wherein the four sub-pixels may include a first sub-pixel P1 that emits light of a first color, a second sub-pixel P2 that emits light of a second color, a third sub-pixel P3 that emits light of a third color, and a fourth sub-pixel P4 that emits light of a fourth color. The four sub-pixels may be arranged in a manner of a square, which may effectively increase an aperture ratio and a light transmission area.

In an exemplary implementation mode, in at least one repetitive unit 100, the second sub-pixel P2 may be disposed on a side of the first sub-pixel P1 in a first direction X, the third sub-pixel P3 may be disposed on a side of the first sub-pixel P1 in a second direction Y, the fourth sub-pixel P4 may be disposed on a side of the third sub-pixel P3 in the first direction X, a plurality of sub-pixels sequentially disposed along the first direction X may be referred to as a pixel row, a plurality of sub-pixels sequentially disposed along the second direction Y may be referred to as a pixel column, a plurality of pixel rows and a plurality of pixel columns constitute a pixel array arranged in an array, and the first direction X intersects with the second direction Y.

In an exemplary implementation mode, the first sub-pixel P1 may be a red sub-pixel (R) emitting red light, the second sub-pixel P2 may be a blue sub-pixel (B) emitting blue light, the third sub-pixel P3 may be a white sub-pixel (W) emitting white light, and the fourth sub-pixel P4 may be a green sub-pixel (B) emitting green light. In some possible implementation modes, an arrangement mode of RBWG may be adjusted according to actual needs, which is not specifically limited in the present disclosure.

In an exemplary implementation mode, in a direction perpendicular to the display substrate, the display substrate may at least include a drive circuit layer disposed on a base substrate, and a light emitting structure layer disposed on a side of the drive circuit layer away from the base substrate. In at least one repetitive unit, the drive circuit layer may include a plurality of circuit units, a circuit unit may at least include a pixel drive circuit connected with a scan signal line, a data signal line, and the like, respectively. The pixel drive circuit is configured to receive a data voltage transmitted by the data signal line and output a corresponding current to a light emitting device, under control of the scan signal line. The light emitting structure layer may include a plurality of light emitting units, wherein a light emitting unit may at least include a light emitting device that is connected with a pixel drive circuit of a circuit unit of a sub-pixel where the light emitting device is located, and the light emitting device is configured to emit light with corresponding brightness in response to a current output by the pixel drive circuit of the sub-pixel where the light emitting device is located.

In another exemplary implementation mode, in a direction perpendicular to the display substrate, the display substrate may at least include a drive circuit layer disposed on a base substrate, a color film structure layer disposed on a side of the drive circuit layer away from the base substrate, and a light emitting structure layer disposed on a side of the color film structure layer away from the base substrate. In at least one repetitive unit, the color film structure layer may include a plurality of color film units, wherein a color film unit may at least include a color filter layer configured to enable a corresponding sub-pixel to emit light of a desired color.

In an exemplary implementation mode, the circuit unit mentioned in the present disclosure refers to a region divided according to the pixel drive circuit. The color film unit mentioned in the present disclosure refers to a region divided according to the color filter layer. The light emitting unit mentioned in the present disclosure refers to a region divided according to the light emitting device. Positions of an orthographic projection of the circuit unit on the base substrate, an orthographic projection of the color filter layer on the base substrate, and an orthographic projection of the light emitting unit on the base substrate may, or may not correspond.

In an exemplary embodiment of the present disclosure, positions of an orthographic projection of the circuit unit on the base substrate, an orthographic projection of the color filter layer on the base substrate, and an orthographic projection of the light emitting unit on the base substrate substantially correspond. The circuit unit, the color film unit, and the light emitting unit constitute a sub-pixel, and in following contents, a sub-pixel is uniformly used for referring to a circuit unit, a color film unit, and a light emitting unit.

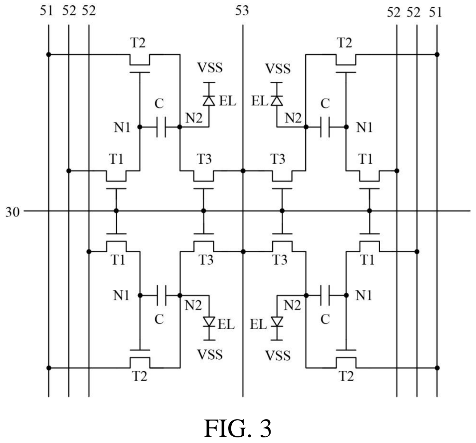

FIG. 3 is an equivalent circuit diagram of a pixel drive circuit in a repetitive unit in an exemplary embodiment of the present disclosure. As shown in FIG. 3, at least one repetitive unit may include four pixel drive circuits that may be arranged in a manner of a square, and a pixel drive circuit may be of a 3T1C structure.

In an exemplary implementation mode, at least one pixel drive circuit may include three transistors (a first transistor T1, a second transistor T2, and a third transistor T3) and one storage capacitor C, and the pixel drive circuit is connected with a scan signal line 30, a first power line 51, a data signal line 52, and a compensation signal line 53, respectively.

In an exemplary implementation mode, each pixel drive circuit may include a first node N1, and a second node N2. The first node N1 is connected with a second electrode of the first transistor T1, a gate electrode of the second transistor T2, and a first terminal of the storage capacitor C, respectively, and the second node N2 is connected with a second electrode of the second transistor T2, a second electrode of the third transistor T3, and a second terminal of the storage capacitor C, respectively.

In an exemplary implementation mode, the first terminal of the storage capacitor C is connected with the first node N1, and the second terminal of the storage capacitor C is connected with the second node N2, the storage capacitor C is used for storing a potential of the gate electrode of the second transistor T2.

In an exemplary implementation mode, the first transistor T1 is a switching transistor, the second transistor T2 is a drive transistor, and the third transistor T3 is a compensation transistor.

In an exemplary implementation mode, a gate electrode of the first transistor T1 is connected with the first scan signal line S1, a first electrode of the first transistor T1 is connected with the data signal line D, and the second electrode of the first transistor T1 is connected with the first node N1. When an on-level signal is applied to the scan signal line 30, the first transistor T1 inputs a data signal from the data signal line 52 to the gate electrode of the second transistor T2.

In an exemplary implementation mode, the gate electrode of the second transistor T2 is connected with the first node N1, a first electrode of the second transistor T2 is connected with the first power line 51, and the second electrode of the second transistor T2 is connected with the second node N2. The second transistor T2 generates a corresponding current at its second electrode under control of a data signal received by the gate electrode thereof.

In an exemplary implementation mode, a gate electrode of the third transistor T3 is connected with the scan signal line 30, a first electrode of the third transistor T3 is connected with the compensation signal line 53, and a second electrode of the third transistor T3 is connected with the second node N2. When an on-level signal is applied to the scan signal line 30, the third transistor T3 extracts a threshold voltage Vth and a mobility of the second transistor T2 in response to a compensation timing, so as to compensate the threshold voltage Vth.

In an exemplary implementation mode, in a pixel drive circuit of at least one sub-pixel, a gate electrode of a first transistor T1 and a gate electrode of a third transistor T3 are connected with a same scan signal line 30.

In an exemplary implementation mode, in a plurality of pixel drive circuits of at least one pixel row, gate electrodes of a plurality of first transistors T1 and gate electrodes of a plurality of third transistors T3 are connected with a same scan signal line 30.

In an exemplary implementation mode, in a plurality of pixel drive circuits of at least one repetitive unit, gate electrodes of a plurality of first transistors T1 and gate electrodes of a plurality of third transistors T3 are connected with a same scan signal line 30.

In an exemplary implementation mode, a light emitting device EL may be an OLED including a first electrode, an organic emitting layer, and a second electrode that are stacked, or may be a QLED including a first electrode, a quantum dot emitting layer, and a second electrode that are stacked. The first electrode of the light emitting device EL is connected with the second node N2, the second electrode of the light emitting device EL is connected with a second power line VSS, and the light emitting device EL emits light with corresponding brightness in response to a current from the second electrode of the second transistor T2. In an exemplary implementation mode, the first electrode may be an anode, and the second electrode may be a cathode. Or, the first electrode may be a cathode, and the second electrode may be an anode.

In an exemplary implementation mode, a signal of the first power line 51 is a high-level signal continuously provided, and a signal of the second power line VSS is a low-level signal continuously provided.

In an exemplary implementation mode, the first transistor T1 to the third transistor T3 may be P-type transistors, or may be N-type transistors. Use of a same type of transistors in a pixel drive circuit may simplify a process flow, reduce a process difficulty of a display panel, and improve a yield of products. In some possible implementation modes, the first transistor T1 to the third transistor T3 may include a P-type transistor and an N-type transistor.

In an exemplary implementation mode, for the first transistor T1 to the third transistor T3, low temperature poly silicon thin film transistors may be used, oxide thin film transistors may be used, or a low temperature poly silicon thin film transistor and an oxide thin film transistor may be used. An active layer of a low temperature poly silicon thin film transistor may be made of Low Temperature Poly Silicon (LTPS), and an active layer of an oxide thin film transistor may be made of an oxide semiconductor (Oxide). The low temperature poly silicon thin film transistor has advantages, such as a high mobility and fast charging, and the oxide thin film transistor has advantages, such a low drain current. The low temperature poly silicon thin film transistor and the oxide thin film transistor are integrated on one display substrate to form an LTPS + Oxide (LTPO) display substrate, so that advantages of the low temperature poly silicon thin film transistor and the oxide thin film transistor may be utilized, low-frequency drive may be achieved, power consumption may be reduced, and display quality may be improved.

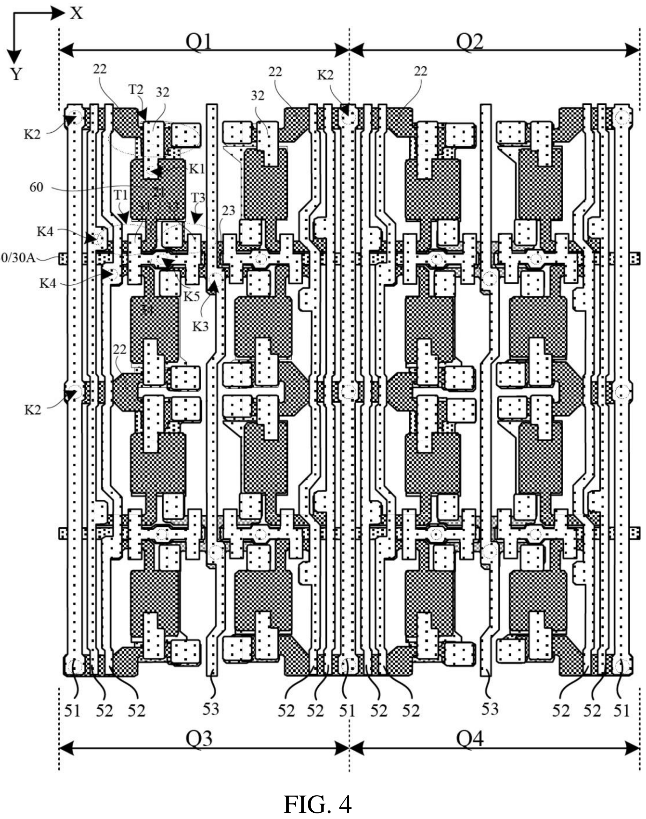

FIG. 4 is a schematic diagram of a structure of a display substrate according to an exemplary embodiment of the present disclosure, illustrating a structure of four repetitive units (sixteen sub-pixels) in a bottom emission display substrate. In an exemplary implementation mode, the four repetitive units may include a first repetitive unit Q1, a second repetitive unit Q2, a third repetitive unit Q3, and a fourth repetitive unit Q4, wherein the second repetitive unit Q2 may be disposed on a side of the first repetitive unit Q1 in a first direction X, the third repetitive unit Q3 may be disposed on a side of the first repetitive unit Q1 in a second direction Y, and the fourth repetitive unit Q4 may be disposed on a side of the third repetitive unit Q3 in the first direction X. At least one repetitive unit may include four sub-pixels forming two pixel rows and two pixel columns, the four sub-pixels may include a first sub-pixel P1, a second sub-pixel P2, a third sub-pixel P3, and a fourth sub-pixel P4, wherein the second sub-pixel P2 may be disposed on a side of the first sub-pixel P1 in the first direction X, the third sub-pixel P3 may be disposed on a side of the first sub-pixel P1 in the second direction Y, and the fourth sub-pixel P4 may be disposed on a side of the third sub-pixel P3 in the first direction X. The first direction X intersects with the second direction Y, a plurality of sub-pixels sequentially disposed along the first direction X may be referred to as a pixel row, a plurality of sub-pixels sequentially disposed along the second direction Y may be referred to as a pixel column, and a plurality of pixel rows and a plurality of pixel columns constitute a pixel array arranged in an array.

In an exemplary implementation mode, at least one sub-pixel may include a pixel drive circuit, a scan signal line 30, and an auxiliary signal line 30A, wherein both of the scan signal line 30 and the auxiliary signal line 30A may be in a line shape in which a main body portion extends along the first direction X (pixel row direction), and both of the scan signal lines 30 and the auxiliary signal line 30A may be disposed in a middle of a repetitive unit in the second direction Y (pixel column direction), and the scan signal line 30 is configured to provide a scan signal to the pixel drive circuit.

In an exemplary implementation mode, at least one pixel drive circuit may include a storage capacitor 60 and at least one transistor, wherein the storage capacitor may include a first electrode plate, and the at least one transistor may be connected with the first electrode plate through a connection electrode. In a direction perpendicular to the display substrate, the display substrate may at least include a first conductive layer disposed on a base substrate, and a second conductive layer disposed on a side of the first conductive layer away from the base substrate, wherein the auxiliary signal line 30A and a first electrode plate may be disposed in the first conductive layer, the scan signal line 30 and the connection electrode may be disposed in the second conductive layer, an orthographic projection of the scan signal line 30 on a plane of the base substrate may be within a range of an orthographic projection of the auxiliary signal line 30A on the plane of the base substrate, and the scan signal line 30 is lapped with the auxiliary signal line 30A to form a signal line with a double-layer structure. In an exemplary implementation mode, the scan signal line 30 is lapped with the auxiliary signal line 30A, which means that a surface of the auxiliary signal line 30A on a side away from the base substrate is attached to a surface of the scan signal line 30 on a side close to the base substrate.

In an exemplary implementation mode, at least one transistor may include a second transistor T2, wherein a second electrode of the second transistor T2 may be connected with the first electrode plate through a connection electrode, the connection electrode may include a first connection electrode and a third connection electrode, the first connection electrode is connected with the first electrode plate, and the third connection electrode is lapped with the first connection electrode.

In an exemplary implementation mode, the storage capacitor may further include a second electrode plate, and an orthographic projection of the second electrode plate on the plane of the base substrate is at least partially overlapped with an orthographic projection of the first electrode plate on the plane of the base substrate. The second transistor T2 may at least include a second gate electrode 32 which may be connected with the second electrode plate through an electrode plate via K1, and an orthographic projection of the second gate electrode 32 on the plane of the base substrate contains an orthographic projection of the electrode plate via K1 on the plane of the base substrate.

In an exemplary implementation mode, the second transistor T2 may further include a second active layer 22, a first region of the second active layer 22 is connected, through a power supply via K2, with a first power line 51, the first power line 51 is configured to supply a power supply signal to the pixel drive circuit, and an orthographic projection of the first power line 51 on the plane of the base substrate contains an orthographic projection of the power supply via K2 on the plane of the base substrate.

In an exemplary implementation mode, first regions of second active layers 22 of two adjacent sub-pixels in two adjacent repetitive units in the first direction X are connected with each other, and/or first regions of second active layers 22 of two adjacent sub-pixels in two adjacent repetitive units in the second direction Y are connected with each other.

In an exemplary implementation mode, second active layers 22 of two adjacent sub-pixels in two adjacent repetitive units in the first direction X are of an interconnected integral structure, and/or second active layers 22 of two adjacent sub-pixels in two adjacent repetitive units in the second direction Y are of an interconnected integral structure.

In an exemplary implementation mode, two adjacent sub-pixels in two adjacent repetitive units in the first direction X share a power supply via K2, and/or two adjacent sub-pixels in two adjacent repetitive units in the second direction Y share a power supply via K2.

In an exemplary implementation mode, at least one transistor may include a third transistor T3, wherein a second electrode of the third transistor T3 may be connected with the first electrode plate through a connection electrode, the connection electrode may include a second connection electrode and a fourth connection electrode, the second connection electrode is connected with the first electrode plate, and the fourth connection electrode is lapped with the second connection electrode.

In an exemplary implementation mode, the third transistor T3 may at least include a third active layer 23, a first region of the third active layer 23 is connected, through a compensation via K3, with a compensation signal line 53, the compensation signal line 53 is configured to provide a compensation signal to the pixel drive circuit, and an orthographic projection of the compensation signal line 53 on the plane of the base substrate contains an orthographic projection of the compensation via K3 on the plane of the base substrate.

In an exemplary implementation mode, in at least one repetitive unit, first regions of third active layers 23 of two adjacent sub-pixels in the first direction X are connected with each other, and/or first regions of third active layers 23 of two adjacent sub-pixels in the second direction Y are connected with each other.

In an exemplary implementation mode, in at least one repetitive unit, third active layers 23 of two adjacent sub-pixels in the first direction X are of an interconnected integral structure, and/or third active layers 23 of two adjacent sub-pixels in the second direction Y are of an interconnected integral structure.

In an exemplary implementation mode, in at least one repetitive unit, two adjacent sub-pixels in the first direction X share a compensation via K3, and/or two adjacent sub-pixels in the second direction Y share a compensation via K3.

In an exemplary implementation mode, the pixel drive circuit may further include a first transistor T1 which may at least include a first active layer 21, a first region of the first active layer 21 is connected, through a data via K4, with a data signal line 52, the data signal line 52 is configured to provide a data signal to the pixel drive circuit, and an orthographic projection of the data signal line 52 on the plane of the base substrate contains an orthographic projection of the data via K4 on the plane of the base substrate.

In an exemplary implementation mode, the first transistor T1 may further include a first gate electrode 31, the third transistor T3 may further include a third gate electrode 33, and the first gate electrode 31 and the third gate electrode 33 are connected with the scan signal line 30 through a gate connection electrode 34, respectively.

In an exemplary implementation mode, in a same sub-pixel, the first gate electrode 31, the third gate electrode 33, and the gate connection electrode 34 may be disposed in a same layer, and are of an interconnected integral structure.

In an exemplary implementation mode, in at least one repetitive unit, first gate electrodes 31, third gate electrodes 33, and gate connection electrodes 34 of two adjacent sub-pixels in the second direction Y may be disposed in a same layer, and are of an interconnected integral structure.

In an exemplary implementation mode, an orthographic projection of a gate connection electrode 34 on the plane of the base substrate is at least partially overlapped with an orthographic projection of the scan signal line 30 on the plane of the base substrate, and the gate connection electrode 34 is connected with the scan signal line 30 through a gate connection via K5.

In an exemplary implementation mode, in at least one repetitive unit, two adjacent sub-pixels in the second direction Y share a gate connection electrode 34.

In an exemplary implementation mode, in at least one repetitive unit, two adjacent sub-pixels in the second direction Y share a gate connection via K5.

In an exemplary implementation mode, at least one repetitive unit may include one scan signal line 30, two first power lines 51, four data signal lines 52, and one compensation signal line 53, and the above-mentioned signal lines are connected with pixel drive circuits in corresponding sub-pixels, respectively. In an exemplary implementation mode, a first power line 51, a data signal line 52, and a compensation signal line 53 may be in a line shape in which a main body portion extends along the second direction Y (pixel column direction), wherein one compensation signal line 53 may be located in a middle of the repetitive unit in the first direction X, two first power lines 51 may be located on both sides of the repetitive unit in the first direction X, four data signal lines 52 and the compensation signal line 53 may be located between the two first power lines 51, two of the four data signal lines 52 may be located on a side of one first power line 51 close to the compensation signal line 53, the other two of the four data signal lines 52 may be located on a side of another first power line 51 close to the compensation signal line 53, and the storage capacitor 60 in the pixel drive circuit may be located between a data signal line 52 and the compensation signal line 53. Thus, one scan signal line 30 extending along the first direction X defines two pixel rows, and one compensation signal line 53 extending along the second direction Y may define two pixel columns, forming a first sub-pixel P1, a second sub-pixel P2, a third sub-pixel P3, and a fourth sub-pixel P4 of one repetitive unit.

In an exemplary implementation mode, two adjacent sub-pixels in two adjacent repetitive units in the first direction X means that in a first repetitive unit Q1 and a second repetitive unit Q2 which are adjacent in the first direction X, a second sub-pixel of the first repetitive unit Q1 and a first sub-pixel of the second repetitive unit Q2 are two adjacent sub-pixels in the first direction X, and a fourth sub-pixel of the first repetitive unit Q1 and a third sub-pixel of the second repetitive unit Q2 are two adjacent sub-pixels in the first direction X. Two adjacent sub-pixels in two adjacent repetitive units in the second direction Y means that in a first repetitive unit Q1 and third repetitive unit Q3 which are adjacent in the second direction Y, a third sub-pixel of the first repetitive unit Q1 and a first sub-pixel of the third repetitive unit Q3 are two adjacent sub-pixels in the second direction Y, and a fourth sub-pixel of the first repetitive unit Q1 and a second sub-pixel of the third repetitive unit Q3 are two adjacent sub-pixels in the second direction Y.

In an exemplary implementation mode, in a direction perpendicular to the display substrate, the display substrate may include a first conductive layer, a second conductive layer, a semiconductor layer, and a third conductive layer that are sequentially disposed on the base substrate, wherein the auxiliary signal line 30A and the first electrode plate of the storage capacitor 60 may be disposed in the first conductive layer, the scan signal line 30 may be disposed in the second conductive layer, the first active layer 21, the second active layer 22, the third active layer 23, and the second electrode plate of the storage capacitor 60 may be disposed in the semiconductor layer, and the first gate electrode 31, the second gate electrode 32, the third gate electrode 33, the gate connection electrode 34, the first power line 51, the data signal line 52, and the compensation signal line 53 may be disposed in the third conductive layer.

Exemplary description is made below through a preparation process of a display substrate. A "patterning process" mentioned in the present disclosure includes film layer deposition, photoresist coating on a film layer, mask exposure, development, etching, photoresist stripping, and other treatments for a metal material, an inorganic material, or a transparent conductive material, and the patterning process includes organic material coating, mask exposure, development, and other treatments for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a material on a base substrate using deposition, coating, or other processes. If the "thin film" does not need to be processed through a patterning process in an entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

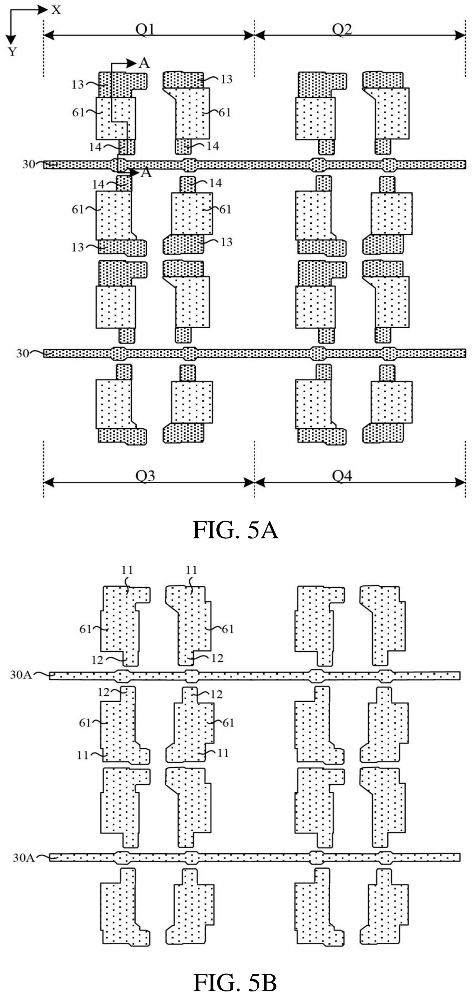

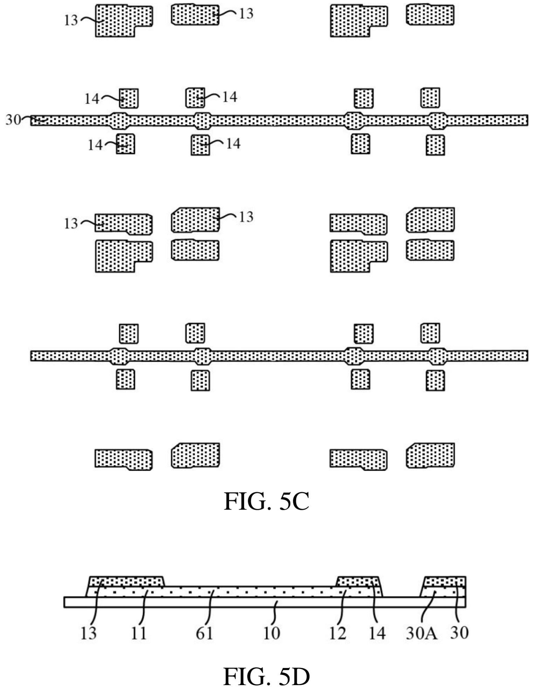

In an exemplary implementation mode, taking four repetitive units (a first repetitive unit Q1, a second repetitive unit Q2, a third repetitive unit Q3, and a fourth repetitive unit Q4) as an example, a preparation process of a display substrate according to an embodiment may include following operations.
(1) Patterns of a first conductive layer and a second conductive layer are formed. In an exemplary implementation mode, forming the patterns of the first conductive layer and the second conductive layer may include: sequentially depositing a first conductive thin film and a second conductive thin film on a base substrate, patterning the first conductive thin film and the second conductive thin film through a patterning process, and forming the patterns of the first conductive layer and the second conductive layer on a base substrate, as shown in FIGs. 5A, 5B, 5C, and 5D, wherein FIG. 5B is a schematic diagram of the first conductive layer in FIG. 5A, FIG. 5C is a schematic diagram of the second conductive layer in FIG. 5A, and FIG. 5D is a cross-sectional view taken along an A-A direction in FIG. 5A. In an exemplary implementation mode, the first conductive layer may be referred to as a first transparent (1ITO) layer, and the second conductive layer may be referred to as a light shielding (SHL) layer.

As shown in FIGs. 5A, 5B, and 5C, a first conductive layer of each sub-pixel in each repetitive unit may at least include a first connection electrode 11, a second connection electrode 12, an auxiliary signal line 30A, and a first electrode plate 61 of a storage capacitor, and a second conductive layer of each sub-pixel in each repetitive unit may at least include a third connection electrode 13, a fourth connection electrode 14, and a scan signal line 30.

In an exemplary implementation mode, the first electrode plate 61 may be in a shape of a rectangle, corners of the rectangle may be provided with chamfers, the first electrode plate 61 may serve as a transparent electrode plate of a transparent storage capacitor, and the first electrode plate 61 is configured to form the transparent storage capacitor, in combination with a second electrode plate formed subsequently.

In an exemplary implementation mode, the first connection electrode 11 and the third connection electrode 13 may be located on one side of the first electrode plate 61 in a second direction Y, and the second connection electrode 12 and the fourth connection electrode 14 may be located on the other side of the first electrode plate 61 in the second direction Y.

In an exemplary implementation mode, in one repetitive unit, first connection electrodes 11 and third connection electrodes 13 in a first sub-pixel P1 and a second sub-pixel P2 may be disposed on a side of the first electrode plate 61 in an opposite direction of the second direction Y, and second connection electrodes 12 and fourth connection electrodes 14 may be disposed on a side of the first electrode plate 61 in the second direction Y. In a third sub-pixel P3 and a fourth sub-pixel P4, first connection electrodes 11 and third connection electrodes 13 may be disposed on a side of the first electrode plate 61 in the second direction Y, and second connection electrodes 12 and fourth connection electrodes 14 may be disposed on a side of the first electrode plate 61 in the opposite direction of the second direction Y.

In an exemplary implementation mode, the first connection electrode 11 and the third connection electrode 13 may be in a block shape (e.g., a rectangle), and an orthographic projection of the third connection electrode 13 on the base substrate is completely overlapped with an orthographic projection of the first connection electrode 11 on the base substrate. A first terminal of the first connection electrode 11 is connected with the first electrode plate 61 and a second terminal of the first connection electrode 11 extends toward a direction away from the first electrode plate 61. The third connection electrode 13 is directly lapped with the first connection electrode 11. On one hand, the third connection electrode 13 is configured to be connected with a fifth connection electrode formed subsequently, on the other hand, the third connection electrode is configured to shade a second transistor, reduce an intensity of light irradiated on the second transistor, reduce a leakage current of the second transistor, thereby reducing an influence of illumination on characteristics of the second transistor.

In an exemplary implementation mode, the second connection electrode 12 and the fourth connection electrode 14 may be in a block shape (e.g., a rectangle), and an orthographic projection of the fourth connection electrode 14 on the base substrate is completely overlapped with an orthographic projection of the second connection electrode 12 on the base substrate. A first terminal of the second connection electrode 12 is connected with the first electrode plate 61 and a second terminal of the second connection electrode 12 extends toward a direction away from the first electrode plate 61. The fourth connection electrode 14 is directly lapped with the second connection electrode 12, and the fourth connection electrode 14 is configured to be connected with a sixth connection electrode formed subsequently.

In an exemplary implementation mode, a first connection electrode 11, a second connection electrode 12, and a first electrode plate 61 of each sub-pixel may be of an interconnected integral structure.

In an exemplary implementation mode, the scan signal line 30 and the auxiliary signal line 30A may be in a line shape in which a main body portion extends along a first direction X, and may be disposed in a middle of a repetitive unit in the second direction Y, that is, located between, the first sub-pixel P1 and the second sub-pixel P2, and the third sub-pixel P3 and the fourth sub-pixel P4. The scan signal line 30 is configured to simultaneously control on or off of all first transistors T1 and all third transistors T3 in four sub-pixels of the repetitive unit.

In an exemplary implementation mode, patterning the first conductive thin film and the second conductive thin film through the patterning process may include: after sequentially depositing the first conductive thin film and the second conductive thin film, coating a layer of photoresist on the second conductive thin film, exposing the photoresist using a half-tone mask, forming a fully exposed region, a partially exposed region, and an unexposed region after development, wherein photoresist in the fully exposed region is removed, the fully exposed region exposes a surface of the second conductive thin film, photoresist in the partially exposed region is partially removed, photoresist in the partially exposed region has a first thickness, photoresist in the unexposed region is not changed and has a second thickness, and the first thickness is less than the second thickness. The unexposed region is a region where the third connection electrode 13, the fourth connection electrode 14, and the scan signal line 30 are located, and the partially exposed region is a region where the first electrode plate 61 is located. Subsequently, the first conductive thin film and the second conductive thin film in the fully exposed region are etched off through a first-time etching process to form patterns of the scan signal line 30 and the auxiliary signal line 30A, wherein an orthographic projection of the scan signal line 30 on the plane of the base substrate is within a range of an orthographic projection of the auxiliary signal line 30A on the plane of the base substrate. The scan signal line 30 is lapped with the auxiliary signal line 30A. That is, a surface of the scan signal line 30 on a side close to the base substrate is attached to a surface of the auxiliary signal line 30A on a side away from the base substrate. Subsequently, photoresist in the partially exposed region is removed using an ashing process, so that the partially exposed region exposes a surface of the second conductive thin film, and the unexposed region is still covered with photoresist. Subsequently, the second conductive thin film in the partially exposed region is etched off through a second-time etching process to expose the first conductive thin film and form patterns of the first connection electrode 11, the second connection electrode 12, the third connection electrode 13, the fourth connection electrode 14, and the first electrode plate 61. An orthographic projection of the third connection electrode 13 on the base substrate is completely overlapped with an orthographic projection of the first connection electrode 11 on the base substrate, the third connection electrode 13 is directly lapped with the first connection electrode 11, an orthographic projection of the fourth connection electrode 14 is completely overlapped with an orthographic projection of the second connection electrode 12 on the base substrate, and the fourth connection electrode 14 is directly lapped with the second connection electrode 12. Finally, remaining photoresist is stripped.

As shown in FIG. 5D, through this patterning process, the first conductive layer and the second conductive layer disposed on a side of the first conductive layer away from the base substrate 10 are formed on the base substrate 10. The first conductive layer may at least include the first connection electrode 11, the second connection electrode 12, the auxiliary signal line 30A, and the first electrode plate 61. The second conductive layer may at least include the third connection electrode 13, the fourth connection electrode 14, and the scan signal line 30. The orthographic projection of the third connection electrode 13 on the base substrate is completely overlapped with the orthographic projection of the first connection electrode 11 on the base substrate, and the third connection electrode 13 is directly lapped with the first connection electrode 11. The orthographic projection of the fourth connection electrode 14 on the base substrate is completely overlapped with the orthographic projection of the second connection electrode 12 on the base substrate, and the fourth connection electrode 14 is directly lapped with the second connection electrode 12.

In the exemplary implementation mode, the scan signal line 30 and the auxiliary signal line 30A form a double-layer signal line structure, which may effectively reduce a resistance of the scan signal line, reduce a voltage drop of a scan signal, and improve display performance.

In an exemplary implementation mode, the first conductive layer may be made of a transparent conductive material, such as Indium Tin Oxide (ITO) and Indium Zinc Oxide (IZO), and the second conductive layer may be made of a metal material, such as any one or more of Argentum (Ag), Copper (Cu), Aluminum (Al), and Molybdenum (Mo), or an alloy material of the above metals, such as an Aluminum-Neodymium alloy (AlNd) or a Molybdenum-Niobium alloy (MoNb), and may be of a single-layer structure or a multi-layer composite structure, such as Mo/Cu/Mo.

In an exemplary implementation mode, in at least one repetitive unit, positions of respective patterns in a first conductive layer and a second conductive layer in a first sub-pixel P1 and positions of respective patterns in a first conductive layer and a second conductive layer in a third sub-pixel P3 may be substantially symmetrical with respect to a horizontal reference line, positions of respective patterns in a first conductive layer and a second conductive layer in a second sub-pixel P2 and positions of respective patterns in a first conductive layer and a second conductive layer in a fourth sub-pixel P4 may be substantially symmetrical with respect to the horizontal reference line, the positions of the respective patterns in the first conductive layer and the second conductive layer in the first sub-pixel P1 and the positions of the respective patterns in the first conductive layer and the second conductive layer in the second sub-pixel P2 may be substantially symmetrical with respect to a vertical reference line, and the positions of the respective patterns in the first conductive layer and the second conductive layer in the third sub-pixel P3 and the positions of the respective patterns in the first conductive layer and the second conductive layer the fourth sub-pixel P4 may be substantially symmetrical with respect to the vertical reference line. The horizontal reference line may be a straight line extending along the first direction X and bisecting the repetitive unit in the second direction Y, and the vertical reference line may be a straight line extending along the second direction Y and bisecting the repetitive unit in the first direction X.

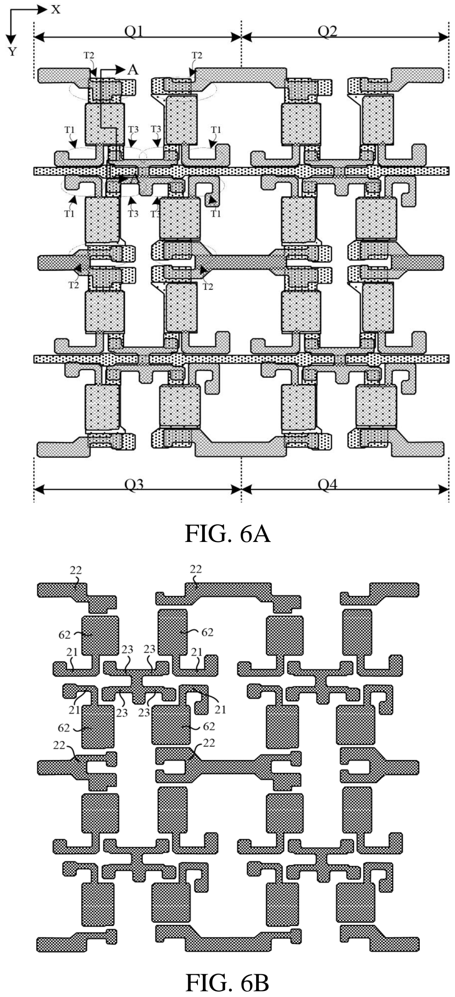

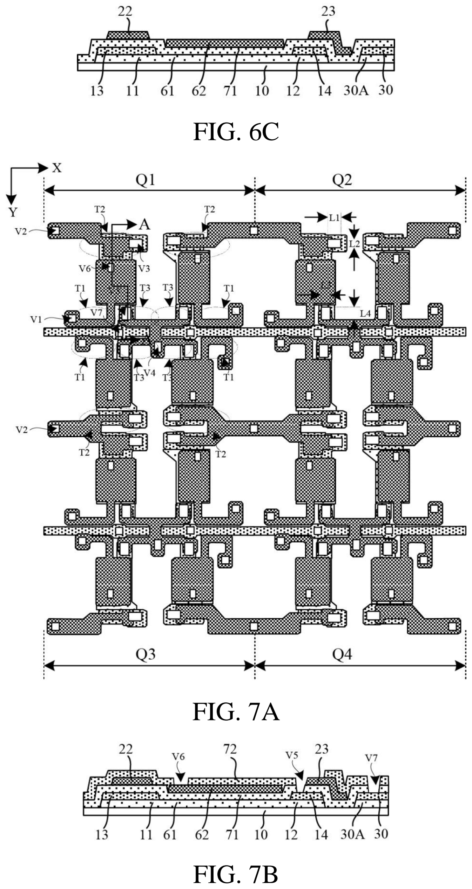

(2) A pattern of a semiconductor layer is formed. In an exemplary implementation mode, forming the pattern of the semiconductor layer may include: sequentially depositing a first insulation thin film and a semiconductor thin film on the base substrate on which the aforementioned patterns are formed, patterning the semiconductor thin film through a patterning process, forming a first insulation layer covering both the first conductive layer and the second conductive layer, and a semiconductor layer disposed on the first insulation layer, as shown in FIGs. 6A, 6B, and 6C, wherein FIG. 6B is a schematic diagram of the semiconductor layer in FIG. 6A, and FIG. 6C is a cross-sectional view taken along an A-A direction in FIG. 6A.

In an exemplary implementation mode, the semiconductor layer of each sub-pixel in each repetitive unit may at least include a first active layer 21 that may serve as an active layer of the first transistor T1, a second active layer 22 that may serve as an active layer of the second transistor T2, a third active layer 23 that may serve as an active layer of the third transistor T3, and a second electrode plate 62 of the storage capacitor that may serve as another transparent electrode plate of the transparent storage capacitor, wherein the second electrode plate 62 is configured to form the transparent storage capacitor in combination with the first electrode plate 61.

In an exemplary implementation mode, the first active layers 21 and the third active layers 23 may be disposed on a side of the first electrode plate 61 of the present sub-pixel close to the scan signal line 30, and the second active layer 22 may be disposed on a side of the first electrode plate 61 of the present sub-pixel away from the scan signal line 30.

In an exemplary implementation mode, an active layer of each transistor may include a first region, a second region, and a channel region located between the first region and the second region.

In an exemplary implementation mode, a first region of a first active layer 21 of each sub-pixel is disposed on a side away from the first electrode plate 61, and a second region of the first active layer 21 is disposed on a side close to the first electrode plate 61 and is connected with the second electrode plate 62.

In an exemplary implementation mode, a first region of a second active layer 22 of each sub-pixel is disposed on a side away from the first electrode plate 61, an orthographic projection of the first region of the second active layer 22 on the base substrate is not overlapped with an orthographic projection of a third connection electrode 13 of the present sub-pixel on the base substrate, a second region of the second active layer 22 is disposed on a side close to the first electrode plate 61, orthographic projections of the second region and a channel region of the second active layer 22 on the base substrate are at least partially overlapped with the orthographic projection of the third connection electrode 13 on the base substrate, so that the third connection electrode 13, serving as a shielding layer, may block a channel region of the second transistor T2, avoid an influence of light on a channel, and guarantee electrical performance of the second transistor T2.

In an exemplary implementation mode, first regions of second active layer 22 of two adjacent sub-pixels in two adjacent repetitive units in the first direction X may be connected with each other, so that second transistors of the two adjacent sub-pixels in the two adjacent repetitive units in the first direction X share a first region of a second active layer. For example, for a first repetitive unit Q1 and a second repetitive unit Q2 adjacent in the first direction X, a first region of a second active layer 22 of a second sub-pixel P2 in the first repetitive unit Q1 and a first region of a second active layer 22 of a first sub-pixel P1 in the second repetitive unit Q2 are connected with each other. A first region of a second active layer 22 of a fourth sub-pixel P4 in the first repetitive unit Q1 and a first region of a second active layer 22 of a third sub-pixel P3 in the second repetitive unit Q2 are connected with each other. For another example, for a third repetitive unit Q3 and a fourth repetitive unit Q4 adjacent in the first direction X, a first region of a second active layer 22 of a second sub-pixel P2 in the third repetitive unit Q3 and a first region of a second active layer 22 of a first sub-pixel P1 in the fourth repetitive unit Q4 are connected with each other. A first region of a second active layer 22 of a fourth sub-pixel P4 in the third repetitive unit Q3 and a first region of a second active layer 22 of a third sub-pixel P3 in the fourth repetitive unit Q4 are connected with each other.

In an exemplary implementation mode, first regions of second active layers 22 of two adjacent sub-pixels in two adjacent repetitive units in the first direction X are of an interconnected integral structure.

In an exemplary implementation mode, first regions of second active layer 22 of two adjacent sub-pixels in two adjacent repetitive units in the second direction Y may be connected with each other, so that second transistors of the two adjacent sub-pixels in the two adjacent repetitive units in the second direction Y share a first region of a second active layer. For example, for a first repetitive unit Q1 and a third repetitive unit Q3 adjacent in the second direction Y, a first region of a second active layer 22 of a third sub-pixel P3 in the first repetitive unit Q1 and a first region of a second active layer 22 of a first sub-pixel P1 in the third repetitive unit Q3 may be connected with each other, and a first region of a second active layer 22 of a fourth sub-pixel P4 in the first repetitive unit Q1 and a first region of a second active layer 22 of a second sub-pixel P2 in the third repetitive unit Q3 may be connected with each other. For another example, for a second repetitive unit Q2 and a fourth repetitive unit Q4 adjacent in the second direction Y, a first region of a second active layer 22 of a third sub-pixel P3 in the second repetitive unit Q2 and a first region of a second active layer 22 of a first sub-pixel P1 in the fourth repetitive unit Q4 may be connected with each other, and a first region of a second active layer 22 of a fourth sub-pixel P4 in the second repetitive unit Q2 and a first region of a second active layer 22 of a second sub-pixel P2 in the fourth repetitive unit Q4 may be connected with each other.

In an exemplary implementation mode, second active layers 22 of two adjacent sub-pixels in two adjacent repetitive units in the second direction Y may be of an interconnected integral structure.

In an exemplary implementation mode, first regions of second active layers 22 of adjacent sub-pixels in adjacent repetitive units in the first direction X and the second direction Y may be connected with each other. For example, a first region of a second active layer 22 of a fourth sub-pixel P4 in the first repetitive unit Q1, a first region of a second active layer 22 of a third sub-pixel P3 in the second repetitive unit Q2, a first region of a second active layer 22 of a second sub-pixel P2 in the third repetitive unit Q3, and a first region of a second active layer 22 of a first sub-pixel P1 in the fourth repetitive unit Q4 may be connected with each other.

In an exemplary implementation mode, second active layers 22 of adjacent sub-pixels in adjacent repetitive units in the first direction X and the second direction Y may be of an interconnected integral structure. According to the present disclosure, by setting second transistors of four adjacent sub-pixels in adjacent repetitive units to share a first region of a second active layer, not only a quantity of vias may be effectively reduced, an occupied area of a pixel drive circuit may be reduced, a pixel aperture ratio may be increased, and a display resolution may be improved, but also a preparation process may be simplified by reducing the vias, a production cost may be reduced, and a product yield may be improved.

In an exemplary implementation mode, a first region of a third active layer 23 of each sub-pixel is disposed on a side away from the first electrode plate 61, and a second region of the third active layer 23 is disposed on a side close to the first electrode plate 61, and an orthographic projection of the second region of the third active layer 23 on the base substrate is at least partially overlapped with an orthographic projection of a fourth connection electrode 14 of the present sub-pixel on the base substrate.

In an exemplary implementation mode, in at least one repetitive unit, a first region of a third active layer 23 in a first sub-pixel P1 and a first region of a third active layer 23 in a second sub-pixel P2 may be connected with each other, and a first region of a third active layer 23 in a third sub-pixel P3 and a first region of a third active layer 23 in a fourth sub-pixel P4 may be connected with each other. That is, first regions of third active layers 23 of two adjacent sub-pixels in one pixel row are connected with each other, so that third transistors of the two adjacent sub-pixels in one pixel row share a first region of a third active layer.

In an exemplary implementation mode, the third active layer 23 in the first sub-pixel P1 and the third active layer 23 in the second sub-pixel P2 may be of an interconnected integral structure, the third active layer 23 in the third sub-pixel P3 and the third active layer 23 in the fourth sub-pixel P4 may be of an interconnected integral structure. That is, third active layers 23 of two adjacent sub-pixels in one pixel row may be of an interconnected integral structure.

In an exemplary implementation mode, in at least one repetitive unit, a first region of a third active layer 23 in a first sub-pixel P1 and a first region of a third active layer 23 in a third sub-pixel P3 may be connected with each other, and a first region of a third active layer 23 in a second sub-pixel P2 and a first region of a third active layer 23 in a fourth sub-pixel P4 may be connected with each other. That is, first regions of third active layer 23 of two adjacent sub-pixels in one pixel column are connected with each other, so that third transistors of the two adjacent sub-pixels in one pixel column share a first region of a third active layer.

In an exemplary implementation mode, the third active layer 23 in the first sub-pixel P1 and the third active layer 23 in the third sub-pixel P3 may be of an interconnected integral structure, and the third active layer 23 in the second sub-pixel P2 and the third active layer 23 in the fourth sub-pixel P4 may be of an interconnected integral structure. That is, third active layers 23 of two adjacent sub-pixels in one pixel column may be of an interconnected integral structure.

In an exemplary implementation mode, in at least one repetitive unit, first regions of third active layers 23 of adjacent sub-pixels may be connected with each other. For example, first regions of third active layers 23 of a first sub-pixel P1, a second sub-pixel P2, a third sub-pixel P3, and a fourth sub-pixel P4 may be connected with each other.

In an exemplary implementation mode, in at least one repetitive unit, third active layers 23 of adjacent sub-pixels may be of an interconnected integral structure. According to the present disclosure, by setting third transistors of adjacent sub-pixels to share a first region of a third active layer, not only a quantity of vias may be effectively reduced, an occupied area of a pixel drive circuit may be reduced, a pixel aperture ratio may be increased, and a display resolution may be improved, but also a preparation process may be simplified by reducing the vias, a production cost may be reduced, and a product yield may be improved.

In an exemplary implementation mode, the second electrode plate 62 may be in a shape of a rectangle, corners of the rectangle may be provided with chamfers, and may be disposed between a second active layer 22 and a third active layer 23 of a present sub-pixel, an orthographic projection of the second electrode plate 62 on the base substrate is at least partially overlapped with an orthographic projection of the first electrode plate 61 on the base substrate, the second electrode plate 62 may serve as another transparent electrode plate of the transparent storage capacitor, and the first electrode plate 61 and the second electrode plate 62 form the transparent storage capacitor.

In an exemplary implementation mode, a second electrode plate 62 and a first active layer 21 of each sub-pixel may be of an interconnected integral structure.

In an exemplary implementation mode, in respective sub-pixels, an area of an overlapping region of an orthographic projection of a first electrode plate 61 on the base substrate with an orthographic projection of a second electrode plate 62 on the base substrate may be substantially the same, so that capacities of storage capacitors in respective sub-pixels are substantially the same.

In an exemplary implementation mode, patterning the semiconductor thin film through the patterning process may include: after depositing the semiconductor thin film, coating a layer of photoresist on the semiconductor thin film, exposing the photoresist using a half-tone mask, forming a fully exposed region, a partially exposed region, and an unexposed region after development, wherein photoresist in the fully exposed region is removed, the fully exposes region exposes a surface of the semiconductor thin film, photoresist in the partially exposed region is partially removed, photoresist in the partially exposed region has a first thickness, photoresist in the unexposed region is not changed and has a second thickness, and the first thickness is less than the second thickness. The unexposed region is a channel region of each active layer, and the partially exposed region is a region which needs a conductorization treatment. Subsequently, the semiconductor thin film in the fully exposed region is etched off through an etching process to form patterns of the first active layer 21, the second active layer 22, the third active layer 23, and the second electrode plate 62. Subsequently, the photoresist in the partially exposed region is removed using an ashing process, so that the partially exposed region exposes the semiconductor layer, and the unexposed region is still covered with photoresist. That is, a channel region of each active layer is covered with photoresist, and a region outside the channel region is exposed. Subsequently, the conductorization treatment is performed on the semiconductor layer of the partially exposed region to form a conductorized second electrode plate 62 and a conductorized first region and a conductorized second region of each active layer. Finally, remaining photoresist is stripped.

As shown in FIG. 6C, after this patterning process, a first insulation layer 71 covering the first conductive layer and the second conductive layer, and a semiconductor layer disposed on a side of the first insulation layer 71 away from the base substrate 10 are formed, wherein the semiconductor layer may at least include a second active layer 22, a third active layer 23, and a second electrode plate 62, an orthographic projection of the second electrode plate 62 on the base substrate is at least partially overlapped with an orthographic projection of a first electrode plate 61 on the base substrate, and the first electrode plate 61 and the second electrode plate 62 form a transparent storage capacitor.

In an exemplary implementation mode, the semiconductor layer may be made of a metal oxide, such as an oxide containing indium and tin, an oxide containing tungsten and indium, an oxide containing tungsten, indium, and zinc, an oxide containing titanium and indium, an oxide containing titanium, indium, and tin, an oxide containing indium and zinc, an oxide containing silicon, indium, and tin, an oxide containing indium, gallium, and zinc. The semiconductor layer may be a single layer, a double-layer, or a multi-layer.

In an exemplary implementation mode, in at least one repetitive unit, positions of respective patterns in the semiconductor layer in the first sub-pixel P1 and positions of respective patterns in the semiconductor layer in the third sub-pixel P3 may be substantially symmetrical with respect to a horizontal reference line, positions of respective patterns in the semiconductor layer in the second sub-pixel P2 and positions of respective patterns in the semiconductor layer in the fourth sub-pixel P4 may be substantially symmetrical with respect to the horizontal reference line, the positions of the respective patterns in the semiconductor layer in the first sub-pixel P1 and the positions of the respective patterns in the semiconductor layer in the second sub-pixel P2 may be substantially symmetrical with respect to a vertical reference line, and the positions of the respective patterns in the semiconductor layer in the third sub-pixel P3 and the positions of the respective patterns in the semiconductor layer in the fourth sub-pixel P4 may be substantially symmetrical with respect to the vertical reference line.

(3) A pattern of a second insulation layer is formed. In an exemplary implementation mode, forming the pattern of the second insulation layer may include: depositing a second insulation thin film on the base substrate on which aforementioned patterns are formed, and patterning the second insulation thin film through a patterning process to form the pattern of the second insulation layer covering the semiconductor layer, wherein a plurality of vias are disposed on the second insulation layer, as shown in FIGs. 7A and 7B, wherein FIG. 7B is a cross-sectional view taken along an A-A direction in FIG. 7A.

In an exemplary implementation mode, a plurality of vias of each sub-pixel in each repetitive unit at least include a first via V1, a second via V2, a third via V3, a fourth via V4, a fifth via V5, a sixth via V6, and a seventh via V7.

In an exemplary implementation mode, an orthographic projection of the first via V1 on the base substrate is within a range of an orthographic projection of the first region of the first active layer 21 on the base substrate, the second insulation layer within the first via V1 is etched off to expose a surface of the first region of the first active layer 21, and the first via V1 is configured such that a data signal line formed subsequently is connected with the first region of the first active layer 21 through the via. In an exemplary implementation mode, the first via V1 may serve as a data via in the present disclosure.

In an exemplary implementation mode, an orthographic projection of the second via V2 on the base substrate is within a range of an orthographic projection of the first region of the second active layer 22 on the base substrate. The second insulation layer within the second via V2 is etched off to expose a surface of the first region of the second active layer 22, and the second via V2 is configured such that a first power line formed subsequently is connected with the first region of the second active layer 22 through the via. In an exemplary implementation mode, the second via V2 may serve as a power supply via in the present disclosure.

In an exemplary implementation mode, since first regions of second active layers 22 of two adjacent sub-pixels in two adjacent repetitive units in the first direction X are connected with each other, the two adjacent sub-pixels in the two adjacent repetitive units in the first direction X may share a same second via V2. For example, a second sub-pixel P2 of a first repetitive unit Q1 and a first sub-pixel P1 of a second repetitive unit Q2 may share a same second via V2. For another example, a fourth sub-pixel P4 of the first repetitive unit Q1 and a third sub-pixel P3 of the second repetitive unit Q2 may share a same second via V2.

In an exemplary implementation mode, since first regions of second active layers 22 of two adjacent sub-pixels in two adjacent repetitive units in the second direction Y are connected with each other, the two adjacent sub-pixels in the two adjacent repetitive units in the second direction Y may share a same second via V2. For example, a third sub-pixel P3 of a first repetitive unit Q1 and a first sub-pixel P1 of a third repetitive unit Q3 may share a same second via V2. For another example, a fourth sub-pixel P4 of the first repetitive unit Q1 and a second sub-pixel P2 of the third repetitive unit Q2 may share a same second via V2.

In an exemplary implementation mode, adjacent sub-pixels in adjacent repetitive units in the first direction X and the second direction Y share a same second via V2. That is, four adjacent sub-pixels in adjacent repetitive units share a same second via V2. For example, for a first repetitive unit Q1 and a second repetitive unit Q2 adjacent in the first direction X, a fourth sub-pixel P4 of the first repetitive unit Q1 and a third sub-pixel P3 of the second repetitive unit Q2 are two adjacent sub-pixels. For a third repetitive unit Q3 and a fourth repetitive unit Q4 adjacent in the first direction X, a second sub-pixel P2 of the third repetitive unit Q3 and a first sub-pixel P1 of the fourth repetitive unit Q4 are two adjacent sub-pixels. For a first repetitive unit Q1 and a third repetitive unit Q3 adjacent in the second direction Y, a fourth sub-pixel P4 of the first repetitive unit Q1 and a second sub-pixel P2 of the third repetitive unit Q3 are two adjacent sub-pixels. For a second repetitive unit Q2 and a fourth repetitive unit Q4 adjacent in the second direction Y, a third sub-pixel P3 of the second repetitive unit Q2 and a first sub-pixel P1 of the fourth repetitive unit Q4 are two adjacent sub-pixels, and the fourth sub-pixel P4 of the first repetitive unit Q1, the third sub-pixel P3 of the second repetitive unit Q2, the second sub-pixel P2 of the third repetitive unit Q3, and the first sub-pixel P1 of the fourth repetitive unit Q4 share a same second via V2. According to the present disclosure, by setting four adjacent sub-pixels in adjacent repetitive units to share a same second via V2, not only a quantity of vias may be effectively reduced, an occupied area of a pixel drive circuit may be reduced, a pixel aperture ratio may be increased, and a display resolution may be improved, but also a preparation process may be simplified by reducing the vias, a production cost may be reduced, and a product yield may be improved.

In an exemplary implementation mode, an orthographic projection of the third via V3 on the base substrate is within a range of orthographic projections of the second region of the second active layer 22 and the third connection electrode 13 on the base substrate. The third via V3 is a via with a transfer structure, includes a shallow half-hole and a deep half-hole, wherein the second insulation layer within the shallow half-hole is etched off to expose a surface of the second region of the second active layer 22, the first insulation layer and the second insulation layer within the deep half-hole are etched off to expose a surface of the third connection electrode 13, so that the via with the transfer structure composed of the two half-holes simultaneously exposes the second region of the second active layer 22 and the third connection electrode 13. The third via V3 is configured such that a fifth connection electrode formed subsequently is connected with the second region of the second active layer 22 and the third connection electrode 13 through the via, and the third via V3 may serve as a first lap via in the present disclosure.

In an exemplary implementation mode, a first dimension L1 of the third via V3 may be greater than a second dimension L2 of the third via V3, wherein the first dimension L1 is a dimension of the third via V3 in the first direction X, and the second dimension L2 is a dimension of the third via V3 in the second direction Y.

In an exemplary implementation mode, the second via V2 and the third via V3 are not on a straight line extending along the first direction X.

In an exemplary implementation mode, in the second direction Y, a second via V2 shared by two adjacent sub-pixels in two adjacent repetitive units may be located between two adjacent third vias V3 in two adjacent repetitive units.

In an exemplary implementation mode, an orthographic projection of the fourth via V4 on the base substrate is within a range of an orthographic projection of the first region of the third active layer 23 on the base substrate, the second insulation layer within the fourth via V4 is etched off to expose a surface of the first region of the third active layer 23, and the fourth via V4 is configured such that a compensation signal line formed subsequently is connected with the first region of the third active layer 23 through the via. In an exemplary implementation mode, the fourth via V4 may serve as a compensation via in the present disclosure.

In an exemplary implementation mode, in one repetitive unit, since first regions of third active layers 23 of two adjacent sub-pixels in the first direction X are connected with each other, the two adjacent sub-pixels in the first direction X may share a same fourth via V4.

In an exemplary implementation mode, in one repetitive unit, since first regions of third active layers 23 of two adjacent sub-pixels in the second direction Y are connected with each other, the two adjacent sub-pixels in the second direction Y may share a same fourth via V4.

In an exemplary implementation mode, in one repetitive unit, since first regions of third active layers of four sub-pixels are connected with each other, a first sub-pixel P1, a second sub-pixel P2, a third sub-pixel P3, and a fourth sub-pixel P4 may share a same fourth via V4. According to the present disclosure, by setting adjacent sub-pixels to share a same fourth via V4, not only a quantity of vias may be effectively reduced, an occupied area of a pixel drive circuit may be reduced, a pixel aperture ratio may be increased, and a display resolution may be improved, but also a preparation process may be simplified by reducing the vias, a production cost may be reduced, and a product yield may be improved.

In an exemplary implementation mode, an orthographic projection of the fifth via V5 on the base substrate is within a range of orthographic projections of the second region of the third active layer 23 and the fourth connection electrode 14 on the base substrate. The fifth via V5 is a via with a transfer structure, includes a shallow half-hole and a deep half-hole, wherein the second insulation layer within the shallow half-hole is etched off to expose a surface of the second region of the third active layer 23, the first insulation layer and the second insulation layer within the deep half-hole are etched off to expose a surface of the fourth connection electrode 14, so that the via with the transfer structure composed of the two half-holes simultaneously exposes the second region of the third active layer 23 and the fourth connection electrode 14. The fifth via V5 is configured such that a sixth connection electrode subsequently formed is connected with the second region of the third active layer 23 and the fourth connection electrode 14 through the via, and the fifth via V5 may serve as a second lap via in the present disclosure.

In an exemplary implementation mode, a third dimension L3 of the fifth via V5 may be greater than a fourth dimension L4 of the fifth via V5, wherein the third dimension L3 is a dimension of the fifth via V5 in the first direction X, and the fourth dimension L4 is a dimension of the fifth via V5 in the second direction Y.

In an exemplary implementation mode, an orthographic projection of the sixth via V6 on the base substrate is within a range of an orthographic projection of the second electrode plate 62 on the base substrate, the second insulation layer within the sixth via V6 is etched off to expose a surface of the second electrode plate 62, and the sixth via V6 is configured such that a second gate electrode formed subsequently is connected with the second electrode plate 62 through the via. In an exemplary implementation mode, the sixth via V6 may serve as an electrode plate via in the present disclosure.

In an exemplary implementation mode, an orthographic projection of the seventh via V7 on the base substrate is within a range of an orthographic projection of the scan signal line 30 on the base substrate, the first insulation layer and the second insulation layer within the seventh via V7 are etched off to expose a surface of the scan signal line 30, and the seventh via V7 is configured such that a gate connection electrode formed subsequently is connected with the scan signal line 30 through the via. In the exemplary embodiment, the seventh via V7 serves as a gate connection via in the embodiment.

In an exemplary implementation mode, in at least one repetitive unit, a first sub-pixel P1 and a third sub-pixel P3 may share a seventh via V7, and a second sub-pixel P2 and a fourth sub-pixel P4 may share a seventh via V7. That is, two adjacent sub-pixels in the second direction Y share a seventh via V7. According to the present disclosure, by setting two adjacent sub-pixels to share a same seventh via V7, not only a quantity of vias may be effectively reduced, an occupied area of a pixel drive circuit may be reduced, a pixel aperture ratio may be increased, and a display resolution may be improved, but also a preparation process may be simplified by reducing the vias, a production cost may be reduced, and a product yield may be improved.

As shown in FIG. 7B, after this patterning process, a second insulation layer 72 covering the semiconductor layer is formed, and at least a fifth via V5, a sixth via V6, and a seventh via V7 are disposed on the second insulation layer 72. The fifth via V5 includes a shallow half-hole and a deep half-hole, the second insulation layer 72 within the shallow half-hole is etched off to expose a surface of the third active layer 23, and a first insulation layer 71 and the second insulation layer 72 within the deep half-hole are etched off to expose a surface of the fourth connection electrode 14, so that the fifth via V5 with a transfer structure composed of the two half-holes simultaneously exposes the third active layer 23 and the fourth connection electrode 14. The second insulation layer 72 within the sixth via V6 is etched off, exposing a surface of the second electrode plate 62. The first insulation layer 71 and the second insulation layer 72 within the seventh via V7 are etched off to expose a surface of the scan signal line 30.

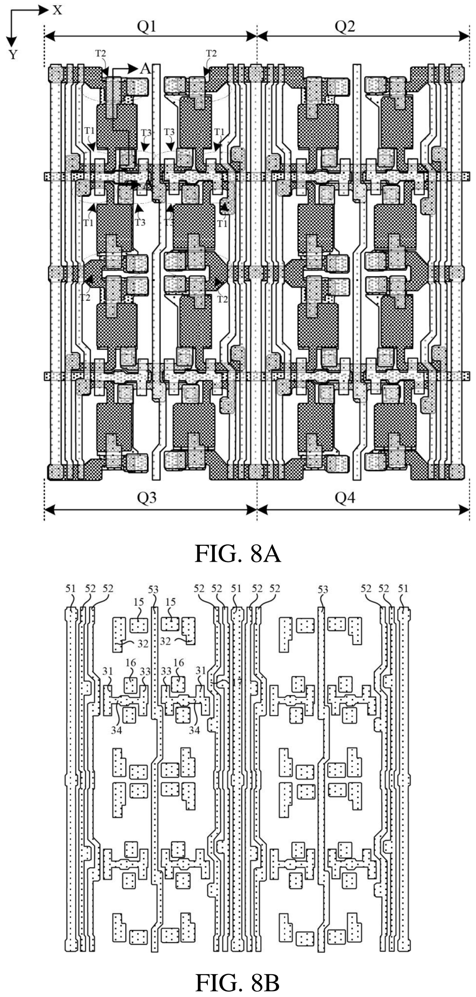

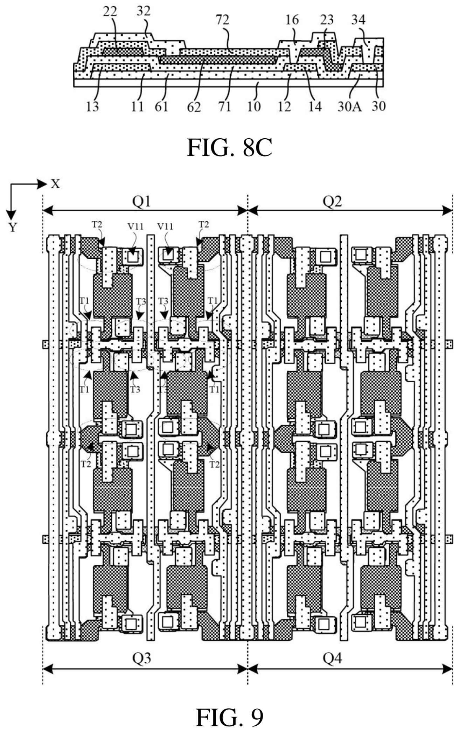

(4) A pattern of a third conductive layer is formed. In an exemplary implementation mode, forming the pattern of the third conductive layer may include: depositing a third conductive thin film on the base substrate on which aforementioned patterns are formed, patterning the third conductive film through a patterning process, and forming a pattern of a third conductive layer on the second insulation layer, as shown in FIGs. 8A, 8B, and 8C, wherein FIG. 8B is a schematic view of the third conductive layer in FIG. 8A, and FIG. 8C is a cross-sectional view taken along an A-A direction in FIG. 8A. In an exemplary implementation mode, the third conductive layer may be referred to as a Gate metal (GT) layer.

In an exemplary implementation mode, the third conductive layer of each sub-pixel in each repetitive unit may at least include a fifth connection electrode 15, a sixth connection electrode 16, a first gate electrode 31, a second gate electrode 32, a third gate electrode 33, and a gate connection electrode 34.

In an exemplary implementation mode, the fifth connection electrode 15 may be in a block shape (such as a rectangle), and may be disposed on a side of the second electrode plate 62 away from the scan signal line 30. The fifth connection electrode 15 is simultaneously connected with the second region of the second active layer 22 and the third connection electrode 13 through the third via V3.

In an exemplary implementation mode, an orthographic projection of the fifth connection electrode 15 on the base substrate may contain an orthographic projection of the third via V3 on the base substrate.

In an exemplary implementation mode, since the fifth connection electrode 15 is simultaneously connected with the second region of the second active layer 22 and the third connection electrode 13, the third connection electrode 13 is connected with the first connection electrode 11, and the first connection electrode 11 is connected with the first electrode plate 61, the fifth connection electrode 15 enables a second electrode of a second transistor and the first electrode plate 61 to have a same potential. In an exemplary implementation mode, the fifth connection electrode 15 is configured to be connected with an anode connection electrode formed subsequently.

In an exemplary implementation mode, the sixth connection electrode 16 may be in a block shape (such as a rectangle), and may be disposed on a side of the second electrode plate 62 close to the scan signal line 30. The sixth connection electrode 16 is simultaneously connected with the second region of the third active layer 23 and the fourth connection electrode 14 through the fifth via V5.

In an exemplary implementation mode, an orthographic projection of the sixth connection electrode 16 on the base substrate may contain an orthographic projection of the fifth via V5 on the base substrate.

In an exemplary implementation mode, since the sixth connection electrode 16 is simultaneously connected with the second region of the third active layer 23 and the fourth connection electrode 14, the fourth connection electrode 14 is connected with the second connection electrode 12, and the second connection electrode 12 is connected with the first electrode plate 61, the sixth connection electrode 16 enables a second electrode of a third transistor and the first electrode plate 61 to have a same potential.

In an exemplary implementation mode, the fifth connection electrode 15 and the sixth connection electrode16 achieve a connection between the second electrode of the second transistor, the second electrode of the third transistor, and the first electrode plate 61 (a second terminal of a storage capacitor), forming a second node in a pixel drive circuit, so that the first electrode plate 61 have a potential of the second node in the pixel drive circuit.

In an exemplary implementation mode, the gate connection electrode 34 may be in a strip shape extending along the first direction X, may be disposed in a middle of a repetitive unit in the second direction Y, i.e., located between, a first sub-pixel P1 and a second sub-pixel P2, and a third sub-pixel P3 and a fourth sub-pixel P4. An orthographic projection of the gate connection electrode 34 on the base substrate is at least partially overlapped with an orthographic projection of the scan signal line 30 on the base substrate, and the gate connection electrode 34 is connected with the scan signal line 30 through the seventh via V7. In an exemplary implementation mode, the orthographic projection of the gate connection electrode 34 on the base substrate may contain an orthographic projection of the seventh via V7 (gate connection via) on the base substrate.

In an exemplary implementation mode, in at least one repetitive unit, a first sub-pixel P1 and a third sub-pixel P3 may share a same gate connection electrode 34, and a second sub-pixel P2 and a fourth sub-pixel P4 may share a same gate connection electrode 34. That is, two adjacent sub-pixels in the second direction Y may share a same gate connection electrode 34. According to the present disclosure, by setting two adjacent sub-pixels to share a same gate connection electrode 34, not only a quantity of connection electrodes may be effectively reduced, an occupied area of a pixel drive circuit may be reduced, a pixel aperture ratio may be increased, and a display resolution may be improved, but also a preparation process may be simplified by reducing the connection electrodes, a production cost may be reduced, and a product yield may be improved.

In an exemplary implementation mode, the first gate electrode 31 may be in a strip shape extending along the second direction Y, may be disposed on a side of the gate connection electrode 34 close to the first active layer 21, wherein a first terminal of the first gate electrode 31 is connected with the gate connection electrode 34, a second terminal of the first gate electrode 31 extends toward a direction of the first active layer 21, and an orthographic projection of the first gate electrode 31 on the base substrate is at least partially overlapped with an orthographic projection of the first active layer 21 on the base substrate. In an exemplary implementation mode, the first gate electrode 31 may serve as a gate electrode of the first transistor T1, which may control on or off of the first transistor T1.

In an exemplary implementation mode, the first gate electrode 31 and the gate connection electrode 34 may be of an interconnected integral structure. Since two adjacent sub-pixels share a same gate connection electrode 34, the gate connection electrode 34 and first gate electrodes 31 of the two adjacent sub-pixels are of an interconnected integral structure. For example, the gate connection electrode 34, a first gate electrode 31 of the first sub-pixel P1, and a first gate electrode 31 of the third sub-pixel P3 are of an interconnected integral structure. For another example, the gate connection electrode 34, a first gate electrode 31 of the second sub-pixel P2, and a first gate electrode 31 of the fourth sub-pixel P4 are of an interconnected integral structure.

In an exemplary implementation mode, the second gate electrode 32 may be in a strip shape extending along the second direction Y, a first terminal of the second gate electrode 32 is connected with the second electrode plate 62 through the sixth via V6, a second terminal of the second gate electrode 32 extends toward a direction of the second active layer 22, and an orthographic projection of the second gate electrode 32 on the base substrate is at least partially overlapped with an orthographic projection of the second active layer 22 on the base substrate. In an exemplary implementation mode, the second gate electrode 32 may serve as a gate electrode of the second transistor T2, which may control on or off of the second transistor T2.

In an exemplary implementation mode, the orthographic projection of the second gate electrode 32 on the base substrate may contain an orthographic projection of the sixth via V6 (electrode plate via) on the base substrate.

In an exemplary implementation mode, since the second gate electrode 32 is connected with the second electrode plate 62, the second electrode plate 62 is connected with the second region of the first active layer 21, it is achieved that the second electrode of the first transistor T1, the gate electrode of the second transistor T2, and the second electrode plate 62 (a first terminal of the storage capacitor) have a same potential, forming a first node in a pixel drive circuit, and the second electrode plate 62 have a potential of the first node in the pixel drive circuit.

In an exemplary implementation mode, since the first electrode plate 61 have the potential of the second node in the pixel drive circuit and the second electrode plate 62 have the potential of the first node in the pixel drive circuit, the first electrode plate 61 have the potential of the second node and the second electrode plate 62 have the potential of the first node form the storage capacitor.

In an exemplary implementation mode, since the first electrode plate 61 is made of a transparent conductive material, and the second electrode plate 62 is made of a transparent metal oxide, the storage capacitor is a transparent capacitor.

In an exemplary implementation mode, the third gate electrode 33 may be in a strip shape extending along the second direction Y, may be disposed on a side of the gate connection electrode 34 close to the third active layer 23, wherein a first terminal of the third gate electrode 33 is connected with the gate connection electrode 34, a second terminal of the third gate electrode 33 extends toward a direction of the third active layer 23, and an orthographic projection of the third gate electrode 33 on the base substrate is at least partially overlapped with an orthographic projection of the third active layer 23 on the base substrate. In an exemplary implementation mode, the third gate electrode 33 may serve as a gate electrode of the third transistor T3, which may control on or off of the third transistor T3.

In an exemplary implementation mode, the third gate electrode 33 and the gate connection electrode 34 may be of an interconnected integral structure. Since two adjacent sub-pixels share a same gate connection electrode 34, the gate connection electrode 34 and third gate electrodes 33 of the two adjacent sub-pixels are of an interconnected integral structure. For example, the gate connection electrode 34, a third gate electrode 33 of the first sub-pixel P1, and a third gate electrode 33 of the third sub-pixel P3 are of an interconnected integral structure. For another example, the gate connection electrode 34, a third gate electrode 33 of the second sub-pixel P2, and a third gate electrode 33 of the fourth sub-pixel P4 are of an interconnected integral structure.

In an exemplary implementation mode, the gate connection electrode 34, and first gate electrodes 31 and third gate electrodes 33 of two adjacent sub-pixels are of an interconnected integral structure. For example, the gate connection electrode 34, a first gate electrode 31 and a third gate electrode 33 of the first sub-pixel P1, and a first gate electrode 31 and a third gate electrode 33 of the third sub-pixel P3 are of an interconnected integral structure. For another example, the gate connection electrode 34, a first gate electrode 31 and a third gate electrode 33 of the second sub-pixel P2, and a first gate electrode 31 and a third gate electrode 33 of the fourth sub-pixel P4 are of an interconnected integral structure.

In an exemplary implementation mode, since the gate connection electrode 34 is connected with the scan signal line 30, in one sub-pixel, one scan signal line 30 is connected with a first gate electrode 31 and a third gate electrode 33 simultaneously, so that the scan signal line 30 may control on or off of a first transistor T1 and a third transistor T3 in one sub-pixel.

In an exemplary implementation mode, in one pixel row, one scan signal line 30 is simultaneously connected with all first gate electrodes 31 and all third transistors 33 in a plurality of sub-pixels through a gate connection electrode 34, so that the scan signal line 30 may control on or off of all first transistors T1 and all third transistors T3 in one pixel row.

In an exemplary implementation mode, in one repetitive unit, one scan signal line 30 is simultaneously connected with all first gate electrodes 31 and all third transistors 33 in a plurality of sub-pixels through a gate connection electrode 34, so that the scan signal line 30 may control on or off of all first transistors T1 and all third transistors T3 in the repetitive unit simultaneously.

In an exemplary implementation mode, the second conductive layer of each repetitive unit in the display substrate may further include two first power lines 51, four data signal lines 52, and one compensation signal line 53.

In an exemplary implementation mode, the first power lines 51, the data signal lines 52, and the compensation signal line 53 may be in a shape of a straight line or in a shape of a polygonal line in which a main body portion extends along the second direction Y. The compensation signal line 53 may be located in a middle of the repetitive unit in the first direction X, a first first power line 51 may be located on a side of the repetitive unit in an opposite direction of the first direction X, a second first power line 51 may be located on a side of the repetitive unit in the first direction X, two of the four data signal lines 52 may be located between the first first power line 51 and the compensation signal line 53, and the other two of the four data signal lines 52 may be located between the second first power line 51 and the compensation signal line 53.

In an exemplary implementation mode, the first first power line 51 and the compensation signal line 53 may define a first pixel column, and two data signal lines 52 are disposed in the first pixel column. The second first power line 51 and the compensation signal line 53 may define a second pixel column, and two data signal lines 52 are disposed in the second pixel column.

In an exemplary implementation mode, the four data signal lines 52 may include a first data signal line and a second data signal line which are disposed in a first pixel column, and a third data signal line and a fourth data signal line which are disposed in a second pixel column. The first data signal line may be disposed on a side of the first first power line 51 in the first direction X, the second data signal line may be disposed on a side of the first data signal line in the first direction X, and the first electrode plate 61 and the second electrode plate 62 may be disposed between the second data signal line and the compensation signal line 53. The fourth data signal line may be disposed on a side of the second first power line 51 in an opposite direction of the first direction X, the third data signal line may be disposed on a side of the fourth data signal line in the opposite direction of the first direction X, and the first electrode plate 61 and the second electrode plate 62 may be located between the compensation signal line 53 and the third data signal line.

In an exemplary implementation mode, two adjacent repetitive units in the first direction X may share a same first power line 51. For example, the first repetitive unit Q1 and the second repetitive unit Q2 may share a same first power line 51. The third repetitive unit Q3 and the fourth repetitive unit Q4 may share a same first power line 51. According to the present disclosure, by setting adjacent repetitive units to share a same first power line, quantities of signal lines and vias may be effectively reduced, an occupied area of a pixel drive circuit may be reduced, a pixel aperture ratio may be increased, and a display resolution may be improved.

In an exemplary implementation mode, a first power line 51 may be connected with a first region of a second active layer 22 through a second via V2, thereby achieving that the first power line 51 writes a first power supply signal into a first electrode of a second transistor T2.

In an exemplary implementation mode, an orthographic projection of the first power line 51 on the base substrate may contain an orthographic projection of the second via (power supply via) on the base substrate.

In an exemplary implementation mode, in each repetitive unit, a first power line 51 of a first pixel column may simultaneously supply a first power supply signal to pixel drive circuits in a first sub-pixel P1 and a third sub-pixel P3, and a first power line 51 of a second pixel column may simultaneously supply a first power supply signal to pixel drive circuits in a second sub-pixel P2 and a fourth sub-pixel P4, so that a first power line 51 in one repetitive unit is of a one-drag-two structure. In the display substrate according to the present disclosure, a first power line is designed to have a one-drag-two structure, which reduces a quantity of signal lines, reduces an occupied area, has a simple structure and a reasonable layout, makes full use of layout space, improves a utilization rate of space, increases a pixel aperture ratio, and improves a display resolution.

In an exemplary implementation mode, two first power lines 51 in one repetitive unit are symmetrically disposed with respect to the compensation signal line 53, a second transistor T2 of a first pixel column and a second transistor T2 of a second pixel column are symmetrically disposed with respect to the compensation signal line 53. Such a symmetrical structure in the present disclosure may ensure that voltage drops of first power lines writing to second transistors T2 are substantially the same, so as to guarantee display uniformity.

In an exemplary implementation mode, a data signal line 52 may be connected with a first region of a first active layer through a first via V1, thereby achieving that the data signal line 52 writes a data signal into a first electrode of a first transistor T1.

In an exemplary implementation mode, an orthographic projection of the data signal line 52 on the base substrate may contain an orthographic projection of the first via V1 (data via) on the base substrate.

In an exemplary implementation mode, the four data signal lines 52 may include a first data signal line, a second data signal line, a third data signal line, and a fourth data signal line. In each repetitive unit, the first data signal line may be connected with a first region of a first active layer of a first sub-pixel P1 through a first via V1, the second data signal line may be connected with a first region of a first active layer of a third sub-pixel P3 through a first via V1, the third data signal line may be connected with a first region of a first active layer of a fourth sub-pixel P4 through a first via V1, and the fourth data signal line may be connected with a first region of a first active layer of a second sub-pixel P2 through a first via V1.

In an exemplary implementation mode, the compensation signal line 53 may be connected with a first region of a third active layer 23 through a fourth via V4, thereby achieving that the compensation signal line 53 writes a compensation signal into a first electrode of a third transistor T3.

In an exemplary implementation mode, an orthographic projection of the compensation signal line 53 on the base substrate may contain an orthographic projection of the fourth via V4 (data via) on the base substrate.

In the exemplary implementation mode, since first regions of third active layers of four sub-pixels in a repetitive unit are connected with each other, and the four sub-pixels share a same fourth via V4, the four sub-pixels share a same compensation signal line 53. That is, four pixel drive circuits in one repetitive unit share a same compensation signal line 53, and the compensation signal line 53 in one repetitive unit is of a one-drag-four structure. In the display substrate according to the present disclosure, the compensation signal line is designed to have a one-drag-four structure, which reduces a quantity of signal lines, reduces an occupied area, has a simple structure and a reasonable layout, makes full use of layout space, improves a utilization rate of space, increases a pixel aperture ratio, and improves a display resolution.

In an exemplary implementation mode, the compensation signal line 53 is disposed between a first pixel column and a second pixel column, and a third transistor T3 of the first pixel column and a third transistor T3 of the second pixel column are symmetrically disposed with respect to the compensation signal line 53. Such a symmetrical structure in the present disclosure may ensure that Resistor-Capacitor (RC) delays of compensation signals writing into third transistors T3 are substantially the same, so as to guarantee display uniformity.

In an exemplary implementation mode, the first power lines 51, the data signal lines 52, and the compensation signal line 53 may be polygonal lines with non-equal widths, and polygonal lines with variable widths may be adopted, which not only may facilitate layout of a pixel structure, but also may reduce parasitic capacitance.

In an exemplary implementation mode, in at least one repetitive unit, positions of two first power lines 51 may be substantially symmetrical with respect to a vertical reference line, and positions of two data signal lines 52 located on a side of the compensation signal line 53 in an opposite direction of the first direction X and positions of two data signal lines 52 located on a side of the compensation signal line 53 in the first direction X may be substantially symmetrical with respect to the vertical reference line.

In an exemplary implementation mode, in at least one repetitive unit, positions of respective patterns in the third conductive layer in the first sub-pixel P1 and positions of respective patterns in the third conductive layer in the third sub-pixel P3 may be substantially symmetrical with respect to a horizontal reference line, positions of respective patterns in the third conductive layer in the second sub-pixel P2 and positions of respective patterns in the third conductive layer in the fourth sub-pixel P4 may be substantially symmetrical with respect to the horizontal reference line, the positions of the respective patterns in the third conductive layer in the first sub-pixel P1 and the positions of the respective patterns in the third conductive layer in the second sub-pixel P2 may be substantially symmetrical with respect to a vertical reference line, and the positions of the respective patterns in the third conductive layer in the third sub-pixel P3 and the positions of the respective patterns in the third conductive layer in the fourth sub-pixel P4 may be substantially symmetrical with respect to the vertical reference line.

As shown in FIG. 8C, after this patterning process, the third conductive layer is formed on the second insulation layer 72, and the third conductive layer at least includes a sixth connection electrode 16, a second gate electrode 32, and a gate connection electrode 34. The sixth connection electrode 16 is connected with the third active layer 23 and the fourth connection electrode 14 simultaneously through a fifth via V5, the second gate electrode 32 is connected with the second electrode plate 62 through a sixth via V6, and the gate connection electrode 34 is connected with the scan signal line 30 through a seventh via V7.

In an exemplary implementation mode, the third conductive layer may be made of a metal material, such as any one or more of Argentum (Ag), Copper (Cu), Aluminum (Al), and Molybdenum (Mo), or an alloy material of the above-mentioned metals, such as an Aluminum-Neodymium alloy (AlNd) or a Molybdenum-Niobium alloy (MoNb), and may be of a single-layer structure, or a multi-layer composite structure such as Mo/Cu/Mo.

(5) A third insulation layer and a pattern of a planarization layer are formed. In an exemplary implementation mode, forming the third insulation layer and the pattern of the planarization layer may include: depositing a third insulation thin film on the base substrate on which aforementioned patterns are formed, then coating a planarization thin film, and patterning the planarization thin film and the third insulation thin film through a patterning process to form a third insulation layer that covers the third conductive layer, and a pattern of a planarization layer disposed on the third insulation layer, wherein the planarization layer is provided with a plurality of vias, as shown in FIG. 9.

In an exemplary implementation mode, vias of each sub-pixel in each repetitive unit at least include an eleventh via V11.

In an exemplary implementation mode, an orthographic projection of the eleventh via V11 on the base substrate is located within a range of an orthographic projection of the fifth connection electrode 15 on the base substrate, the third insulation layer and the planarization layer within the eleventh via V11 are etched off to expose a surface of the fifth connection electrode 15, and the eleventh via V11 is configured such that an anode connection electrode formed subsequently is connected with the fifth connection electrode 15 through the via.

In an exemplary implementation mode, in this process, a one-time patterning process is adopted to form vias on the third insulation layer and the planarization layer simultaneously. That is, the third insulation layer and the planarization layer share a half-tone mask process or a gray-tone mask process once, effectively reducing a quantity of patterning processes.

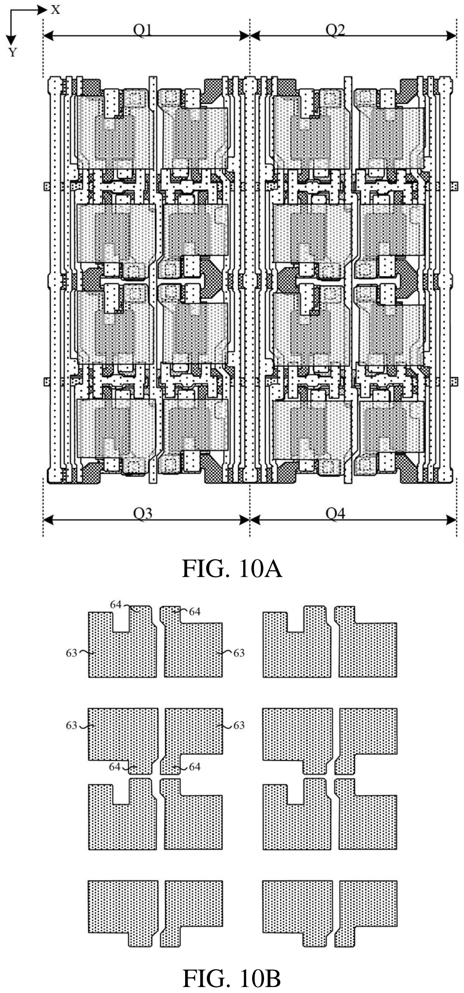

(6) A pattern of a fourth conductive layer is formed. In an exemplary implementation mode, forming the pattern of the fourth conductive layer may include: depositing a fourth conductive thin film on the base substrate on which aforementioned patterns are formed, patterning the fourth conductive thin film through a patterning process, and forming a pattern of a fourth conductive layer on a color film layer, as shown in FIGs. 10A and 10B, wherein FIG. 10B is a schematic diagram of the fourth conductive layer in FIG. 10A. In an exemplary implementation mode, the fourth conductive layer may be referred to as a second transparent (2ITO) layer.

In an exemplary implementation mode, the fourth conductive layer of each sub-pixel in each repetitive unit may at least include a first electrode 63 and an anode connection electrode 64.

In an exemplary implementation mode, the first electrode 63 may be in a shape of a rectangle, corners of the rectangle may be provided with chamfers, grooves, or protrusions, and an orthographic projection of the first electrode 63 on the base substrate is at least partially overlapped with an orthographic projection of the second electrode plate 62 on the base substrate.

In an exemplary implementation mode, the anode connection electrode 64 may be in a block shape (e.g., a rectangle), may be located on a side of the first electrode 63 away from the scan signal line 30, a first terminal of the anode connection electrode 64 is connected with the first electrode 63, a second terminal of the anode connection electrode 64 extends toward a direction away from the scan signal line 30, and is connected with the fifth connection electrode 15 through the eleventh via V11.

In an exemplary implementation mode, in at least one sub-pixel, an anode connection electrode 64 and a first electrode 63 may be of an interconnected integral structure.

In an exemplary implementation mode, in at least one repetitive unit, four first electrodes 63 may be arranged in a square, an upper left first electrode is connected with a pixel drive circuit in a first sub-pixel P1, an upper right first electrode is connected with a pixel drive circuit in a second sub-pixel P2, an lower left first electrode is connected with a pixel drive circuit in a third sub-pixel P3, and a lower right first electrode is connected with a pixel drive circuit in a fourth sub-pixel P4. In some possible implementation modes, the first electrode may serve as an anode of a light emitting device, and an arrangement mode of first electrodes may be adjusted according to actual needs, which is not specifically limited in the present disclosure.

In an exemplary implementation mode, the first conductive layer may be made of a transparent conductive material, such as Indium Tin Oxide (ITO) or Indium Zinc Oxide (IZO).

In an exemplary implementation mode, the first electrode 63 may also serve as an auxiliary capacitor of the storage capacitor. Since the first electrode 63 is connected with the anode connection electrode 64, and the anode connection electrode 64 is connected with the first electrode plate 61 through the fifth connection electrode 15, the third connection electrode 13, and the first connection electrode 11, the first electrode 63 has a potential of the second node in the pixel drive circuit, so that the first electrode 63 having the potential of the second node and the second electrode plate 62 having the potential of the first node forms the auxiliary capacitor, and the auxiliary capacitor and the storage capacitor are connected in parallel. In the present disclosure, the first electrode is used for forming the auxiliary capacitor, and the auxiliary capacitor and the storage capacitor are connected in parallel. Therefore, on the one hand, a capacitance value of the storage capacitor may be effectively increased, on the other hand, an area of an electrode plate may be reduced, under a condition that the capacitance value of the storage capacitor is guaranteed, and an occupied area may be effectively reduced.

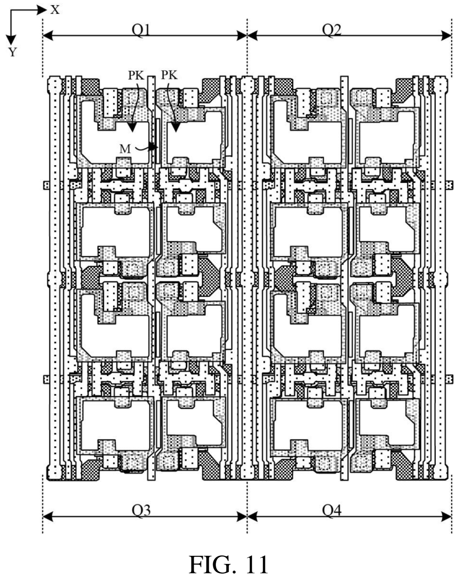

(7) A pixel definition layer is formed. In an exemplary implementation mode, forming a pattern of the pixel definition layer may include: coating a pixel definition thin film on the base substrate on which aforementioned patterns are formed, and patterning the pixel definition thin film through a patterning process to form a pixel definition layer covering the fourth conductive layer, as shown in FIG. 11.

In an exemplary implementation mode, a pixel opening PK is opened on the pixel definition layer of each sub-pixel in each repetitive unit, the pixel definition thin film within the pixel opening PK is removed to expose a part of a surface of the first electrode 63, and an orthographic projection of the pixel opening PK on the base substrate is within a range of an orthographic projection of the first electrode 63 on the base substrate.

In an exemplary implementation mode, a shape of the pixel opening PK may be similar to a shape of the first electrode 63 in a plane parallel to the base substrate, and a cross-sectional shape of the pixel opening PK may be a rectangle, a trapezoid, or the like in a plane perpendicular to the base substrate.

In an exemplary implementation mode, a shape of a pixel opening may include any one or more of following: a triangle, a rectangle, a trapezoid, a parallel four-frame shape, a five-frame shape, a six-frame shape, a circle, and an ellipse.

In an exemplary implementation mode, shapes of pixel openings of four sub-pixels in a repetitive unit may be the same, or may be different. Areas of the pixel openings of the four sub-pixels may be the same, or may be different.

In an exemplary implementation mode, shapes and areas of pixel openings of four sub-pixels in a repetitive unit may be different to adapt to transmittances of different sub-pixel filters, so that light emitting devices of the four sub-pixels may emit same brightness at different currents, service life of the light emitting devices of the four sub-pixels is optimized to a maximum extent, and service life of products is guaranteed.

In an exemplary implementation mode, at least one partition groove M may also be disposed on a pixel definition layer of each repetitive unit, and the partition groove M may be in a strip shape in which a main body portion extends along the second direction Y, and may be disposed between pixel openings PK adjacent in the first direction X. For example, the partition groove M may be disposed between a pixel opening PK of a first sub-pixel P1 and a pixel opening PK of a second sub-pixel P2. For another example, the partition groove M may be disposed between a pixel opening PK of a third sub-pixel P3 and a pixel opening PK of a fourth sub-pixel P4. In an exemplary implementation mode, the partition groove M is configured to cut off an organic emitting layer formed subsequently, block a lateral propagation path of hole-type carriers, eliminate lateral leakage, and eliminate lateral cross-talk of sub-pixels.

In an exemplary implementation mode, the pixel definition layer may be made of polyimide, acrylic, or polyethylene terephthalate.

(8) Patterns of an organic emitting layer and a cathode are formed. In an exemplary implementation mode, forming the patterns of the organic emitting layer and the cathode may include: forming a pattern of an organic emitting layer, wherein the organic emitting layer is connected with the first electrode 63 through the pixel opening PK. Subsequently, a second electrode is formed, and the second electrode is connected with the organic emitting layer. In an exemplary implementation mode, the second electrode may serve as a cathode of a light emitting device.

In an exemplary implementation mode, the organic emitting layer may include an Emitting Layer (EML), and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation mode, the organic emitting layer may be formed by evaporation using a Fine Metal Mask (FMM) or an open mask, or formed by using an inkjet process.

(8) A pattern of an encapsulation structure layer is formed. In an exemplary implementation mode, forming the pattern of the encapsulation structure layer may include: depositing a first inorganic thin film using an open mask, so as to form a first encapsulation layer. Then, inkjet printing an organic material is performed on the first encapsulation layer by using an inkjet printing process, and a second encapsulation layer is formed after curing. Subsequently, a second inorganic thin film is deposited by using an open mask, so as to form a third encapsulation layer, wherein the first encapsulation layer, the second encapsulation layer, and the third encapsulation layer form an encapsulation structure layer. The first encapsulation layer and the third encapsulation layer may be made of any one or more of Silicon Oxide (SiOx), Silicon Nitride (SiNx), Silicon Carbide (SiC), Silicon Carbonitride (SiCN), and Silicon Oxynitride (SiON), and may be a single layer, a multi-layer, or a composite layer. The second encapsulation layer may be made of a resin material, thereby forming a stacked structure of an inorganic material/an organic material/an inorganic material, wherein an organic material layer is disposed between two inorganic material layers, which may guarantee that external water vapor cannot enter a light emitting structure layer.

So far, preparation of the display substrate according to the exemplary embodiment of the present disclosure is completed. The display substrate may include a drive circuit layer disposed on the base substrate, the light emitting structure layer disposed on a side of the drive circuit layer away from the base substrate, and the encapsulation structure layer disposed on a side of the light emitting structure layer away from the base substrate. In a direction perpendicular to the display substrate, the drive circuit layer may include the first conductive layer, the second conductive layer, the first insulation layer, the semiconductor layer, the second insulation layer, the third conductive layer, the third insulation layer, and the planarization layer disposed sequentially on the base substrate, and the light emitting structure layer may include the first electrode, the pixel definition layer, the organic emitting layer, and the second electrode, and the encapsulation structure layer may include the first encapsulation layer, the second encapsulation layer, and the third encapsulation layer stacked.

In an exemplary implementation mode, for the display substrate including a color film structure layer, after forming the third conductive layer, the third insulation layer may be formed at first, then a red color film layer, a green color film layer, and a blue color film layer may be formed sequentially, and then the planarization layer is formed, which will not be repeated herein.

In an exemplary implementation mode, the base substrate may be a flexible base substrate, or a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first insulation layer, the second insulation layer, and the third insulation layer may be made of any one or more of Silicon Oxide (SiOx), Silicon Nitride (SiNx), and Silicon Oxynitride (SiON), and may be a single layer, a multi-layer, or a composite layer. The planarization layer may be made of an organic material, such as resin.

A structure shown in the present disclosure and a preparation process therefor are merely exemplary description. In an exemplary implementation mode, a corresponding structure may be changed and a patterning process may be added or reduced according to actual needs, which is not limited here in the present disclosure.

A display substrate with a bottom emission structure is provided in an embodiment of the present disclosure. A scan signal line is disposed in a light shielding layer and the scan signal line, a first electrode plate, and a plurality of connection electrodes are synchronously formed through a same patterning process, a structure of a pixel drive circuit is optimized, an occupied area of the pixel drive circuit may be effectively reduced, a pixel aperture ratio is increased, and a display resolution is improved.

According to the display substrate in the embodiment of the present disclosure, the first conductive layer and the second conductive layer are synchronously formed in one patterning process, and the scan signal line and the auxiliary signal line form a signal line structure with a double-layer structure, which may effectively reduce a resistance of the scan signal line, reduce a voltage drop of a scan signal, and improve display performance.

According to the display substrate in the embodiment of the present disclosure, the semiconductor layer is formed through a patterning process using the half-tone mask, and a conductorization treatment is completed while forming the semiconductor layer, thus not only a process is simplified and an effect of the conductorization treatment is improved, but also Comparing a via lap mode with an existing structure in which a conductorization treatment is performed after forming a via, the present disclosure not only effectively reduces a dimension of a via, effectively reduces an occupied area of a via connection structure, effectively reduces an occupied area of a pixel drive circuit, increases a pixel aperture ratio, improves a display resolution, but also reduces processing times, effectively improves a production efficiency, effectively reduces a production cost, and maximally improves a product yield.

According to the display substrate in the embodiment of the present disclosure, second active layer of adjacent sub-pixels in adjacent repetitive units are of an interconnected integral structure, third active layers of adjacent sub-pixels are of an interconnected integral structure, and first gate electrodes, third gate electrodes, and gate connection electrodes of two adjacent sub-pixels are of an interconnected integral structure, not only a quantity of vias is effectively reduced, an occupied area of a pixel drive circuit may be reduced, a pixel aperture ratio may be increased, and a display resolution may be improved, but also a preparation process may be simplified by reducing the vias, a production cost may be reduced, and a product yield may be improved.

According to the display substrate in the embodiment of the present disclosure, a scan signal line is disposed in a light shielding layer, and located on a side of a semiconductor layer close to a base substrate, and structures such as a first power line, a data signal line, a compensation signal line, and gate electrodes of a plurality of transistors are disposed in a gate metal layer, and located on a side of the semiconductor layer away from the base substrate, not only one conductive layer is reduced, but also a patterning process of a transfer via and a patterning process of a transfer conductive layer are reduced, so that a preparation process of a drive structure layer needs only five times of patterning (MASK) process. Compared with an existing preparation process requiring nine times of patterning process, for the display substrate of the present disclosure, a quantity of times of patterning process is reduced, a production efficiency is effectively improved, a production cost is effectively reduced, and a product yield is maximized.

According to the display substrate in the embodiment of the present disclosure, through a 3TIC pixel drive circuit using one scan signal line, one scan signal line is connected with a first transistor and a third transistor in the pixel drive circuit. By reducing a quantity of scan signal lines, a structure of the pixel drive circuit may be simplified, and an occupied area of the pixel drive circuit may be reduced, which is beneficial to achieve high-resolution display. In addition, since one repetitive unit only needs one scan signal line to drive, a quantity of corresponding gate drive circuits (GOA) and clock signal lines (CLK) may be reduced by multiple times, occupied areas of the gate drive circuits and clock signal lines are effectively reduced, which is beneficial to achieve a narrow bezel and improve product advantages.

According to the display substrate in the embodiment of the present disclosure, a transparent storage capacitor is composed of a transparent conductive layer and a transparent semiconductor layer, so that light may be emitted through the transparent storage capacitor, the storage capacitor may be disposed within a pixel opening, which not only may effectively increase a capacity of the storage capacitor, but also may effectively increase a pixel opening ratio.

A top gate structure is adopted for a transistor of the display substrate in the embodiment of the present disclosure, which has a relatively high opening current (Ion), a relatively high aperture ratio, and better electrical stability, which is beneficial to achieve a good drive effect, and improve reliability of the display substrate.

According to the display substrate of the embodiment of the present disclosure, a square arrangement mode of sub-pixels is adopted and a first power line structure with a non-mesh structure is adopted, which may effectively increase a pixel aperture ratio, improve a display effect, and is more suitable for display of display types.

The preparation process in the present disclosure may be compatible well with an existing preparation process, is simple in process implementation, is easy to implement, and has a high production efficiency, a low production cost, and a high yield.

In an exemplary implementation mode, the display substrate according to the present disclosure may be applied to a display apparatus with a pixel drive circuit, such as an OLED, quantum dot display (QLED), light emitting diode display (Micro LED or Mini LED), or Quantum Dot Light Emitting Diode display (QDLED), which is not limited here in the present disclosure.

An embodiment of the present disclosure also provides a preparation method of a display substrate, to prepare the aforementioned display substrate. In an exemplary implementation mode, the display substrate includes a plurality of repetitive units, at least one of the repetitive units includes a plurality of sub-pixels forming at least two pixel rows and at least two pixel columns, at least one of the sub-pixels includes a pixel drive circuit, a scan signal line configured to provide a scan signal to the pixel drive circuit, and an auxiliary signal line. The pixel drive circuit includes a storage capacitor and at least one transistor, wherein the storage capacitor at least includes a first electrode plate, and the at least one transistor is connected with the first electrode plate through a connection electrode. The preparation method includes: forming a first conductive layer on a base substrate and a second conductive layer disposed on a side of the first conductive layer away from the base substrate, wherein the auxiliary signal line and the first electrode plate are disposed in the first conductive layer, the scan signal line and the connection electrode are disposed in the second conductive layer, an orthographic projection of the scan signal line on a plane of the base substrate is within a range of an orthographic projection of the auxiliary signal line on the plane of the base substrate, and the scan signal line is lapped with the auxiliary signal line.

In an exemplary implementation mode, forming the first conductive layer on the base substrate and the second conductive layer disposed on the side of the first conductive layer away from the base substrate, includes: depositing a first conductive thin film and a second conductive thin film sequentially; using a patterning process with a half-tone mask to form the scan signal line and the auxiliary signal line through a first-time etching process, and to form the first electrode plate and the connection electrode through a second-time etching process.

In an exemplary implementation mode, the storage capacitor further includes a second electrode plate, and an orthographic projection of the second electrode plate on the plane of the base substrate is at least partially overlapped with an orthographic projection of the first electrode plate on the plane of the base substrate. The preparation method further includes: depositing a semiconductor thin film on a side of the second conductive layer away from the base substrate; using a patterning process with a half-tone mask to form the second electrode plate through an etching process and a conductorization treatment process sequentially.

A display apparatus is also provided in the present disclosure, which includes the display substrate according to the aforementioned embodiments. The display apparatus may be any product or component with a display function, such as a mobile phone, a tablet computer, a television, a display, a laptop computer, a digital photo frame, and a navigator.

Although implementation modes disclosed in the present disclosure are as above, it should be noted that the above-mentioned implementation modes are exemplary only rather than restrictive. Therefore, the present disclosure is not limited to what is specifically shown and described herein. Various modifications, substitutions, or omissions may be made in forms and details of implementation without departing from the scope of the present disclosure.

## Claims

1. A display substrate, comprising a plurality of repetitive units, at least one of the repetitive units comprises a plurality of sub-pixels forming at least two pixel rows and at least two pixel columns, at least one of the sub-pixels comprises a pixel drive circuit, a scan signal line configured to provide a scan signal to the pixel drive circuit, and an auxiliary signal line; the pixel drive circuit comprises a storage capacitor and at least one transistor, wherein the storage capacitor at least comprises a first electrode plate, and the at least one transistor is connected with the first electrode plate through a connection electrode; in a direction perpendicular to the display substrate, the display substrate comprises a first conductive layer disposed on a base substrate, and a second conductive layer disposed on a side of the first conductive layer away from the base substrate, the auxiliary signal line and the first electrode plate are disposed in the first conductive layer, the scan signal line and the connection electrode are disposed in the second conductive layer, an orthographic projection of the scan signal line on a plane of the base substrate is within a range of an orthographic projection of the auxiliary signal line on the plane of the base substrate, and the scan signal line is lapped with the auxiliary signal line.

2. The display substrate according to claim 1, wherein the storage capacitor further comprises a second electrode plate, and an orthographic projection of the second electrode plate on the plane of the base substrate is at least partially overlapped with an orthographic projection of the first electrode plate on the plane of the base substrate; the at least one transistor comprises a second transistor, the second transistor at least comprises a second gate electrode, the second gate electrode is connected with the second electrode plate through an electrode plate via, and an orthographic projection of the second gate electrode on the plane of the base substrate contains an orthographic projection of the electrode plate via on the plane of the base substrate.

3. The display substrate according to claim 2, wherein the second transistor further comprises a second active layer, a first region of the second active layer is connected with a first power line via a power supply via, a second region of the second active layer is connected with the first electrode plate through a connection electrode, the first power line is configured to provide a power supply signal to the pixel drive circuit, and an orthographic projection of the first power line on the plane of the base substrate contains an orthographic projection of the power supply via on the plane of the base substrate.

4. The display substrate according to claim 3, wherein second active layers of two adjacent sub-pixels in two adjacent repetitive units in a pixel row direction are of an interconnected integral structure, and/or, second active layers of two adjacent sub-pixels in two adjacent repetitive units in a pixel column direction are of an interconnected integral structure.

5. The display substrate according to claim 3, wherein two adjacent sub-pixels in two adjacent repetitive units in a pixel row direction share the power supply via, and/or, two adjacent sub-pixels in two adjacent repetitive units in a pixel column direction share the power supply via.

6. The display substrate according to claim 3, wherein the connection electrode comprises a first connection electrode connected with the first electrode plate, and a third connection electrode lapped with the first connection electrode; the pixel drive circuit further comprises a fifth connection electrode, and the fifth connection electrode is simultaneously connected with the second region of the second active layer and the third connection electrode through a first lap via; wherein a first dimension of the first lap via is greater than a second dimension of the first lap via, the first dimension is a dimension of the first lap via in a pixel row direction, and the second dimension is a dimension of the first lap via in a pixel column direction.

7. The display substrate according to claim 6, wherein the power supply via and the first lap via are not on a straight line extending along the pixel row direction.

8. The display substrate according to claim 6, wherein in the pixel column direction, the power supply via shared by two adjacent sub-pixels in two adjacent repetitive units is located between two adjacent first lap vias in two adjacent repetitive units.

9. The display substrate according to claim 1, wherein the at least one transistor comprises a third transistor, the third transistor at least comprises a third active layer, a first region of the third active layer is connected with a compensation signal line through a compensation via, a second region of the third active layer is connected with the first electrode plate through a connection electrode, the compensation signal line is configured to provide a compensation signal to the pixel drive circuit, and an orthographic projection of the compensation signal line on the plane of the base substrate contains an orthographic projection of the compensation via on the plane of the base substrate.

10. The display substrate according to claim 9, wherein in at least one repetitive unit, third active layers of two adjacent sub-pixels in a pixel row direction are of an interconnected integral structure, and/or, third active layers of two adjacent sub-pixels in a pixel column direction are of an interconnected integral structure.

11. The display substrate according to claim 9, wherein in at least one repetitive unit, two adjacent sub-pixels in a pixel row direction share the compensation via, and/or, two adjacent sub-pixels in a pixel column direction share the compensation via.

12. The display substrate according to claim 9, wherein the connection electrode comprises a second connection electrode connected with the first electrode plate, and a fourth connection electrode lapped with the second connection electrode; the pixel drive circuit further comprises a sixth connection electrode, and the sixth connection electrode is simultaneously connected with the second region of the third active layer and the fourth connection electrode through a second lap via; wherein a third dimension of the second lap via is greater than a fourth dimension of the second lap via, the third dimension is a dimension of the second lap via in a pixel row direction, and the fourth dimension is a dimension of the second lap via in a pixel column direction.

13. The display substrate according to claim 9, wherein the pixel drive circuit further comprises a first transistor, the first transistor at least comprises a first active layer, a first region of the first active layer is connected with a data signal line through a data via, the data signal line is configured to provide a data signal to the pixel drive circuit, and an orthographic projection of the data signal line on the plane of the base substrate contains an orthographic projection of the data via on the plane of the base substrate.

14. The display substrate according to any one of claims 1 to 13, wherein the pixel drive circuit at least comprises a first transistor and a third transistor, the first transistor at least comprises a first gate electrode, the third transistor at least comprises a third gate electrode, and the first gate electrode and the third gate electrode are respectively connected with the scan signal line through a gate connection electrode.

15. The display substrate according to claim 14, wherein in at least one repetitive unit, gate connection electrodes, first gate electrodes, and third gate electrodes of two adjacent sub-pixels in a pixel column direction are disposed in a same layer, and are of an interconnected integral structure.

16. The display substrate according to claim 14, wherein an orthographic projection of the gate connection electrode on the plane of the base substrate is at least partially overlapped with an orthographic projection of the scan signal line on the plane of the base substrate, and the gate connection electrode is connected with the scan signal line through a gate connection via.

17. The display substrate according to claim 16, wherein in at least one repetitive unit, two adjacent sub-pixels in a pixel column direction share the gate connection electrode.

18. The display substrate according to claim 16, wherein in at least one repetitive unit, two adjacent sub-pixels in a pixel column direction share the gate connection via.

19. A display apparatus, comprising a display substrate according to any one of claims 1 to 18.

20. A preparation method of a display substrate, wherein the display substrate comprises a plurality of repetitive units, at least one of the repetitive units comprises a plurality of sub-pixels forming at least two pixel rows and at least two pixel columns, at least one of the sub-pixels comprises a pixel drive circuit, a scan signal line configured to provide a scan signal to the pixel drive circuit, and an auxiliary signal line; the pixel drive circuit comprises a storage capacitor and at least one transistor, wherein the storage capacitor at least comprises a first electrode plate, and the at least one transistor is connected with the first electrode plate through a connection electrode; the preparation method comprises:
forming a first conductive layer on a base substrate, and a second conductive layer disposed on a side of the first conductive layer away from the base substrate, wherein the auxiliary signal line and the first electrode plate are disposed in the first conductive layer, the scan signal line and the connection electrode are disposed in the second conductive layer, an orthographic projection of the scan signal line on a plane of the base substrate is within a range of an orthographic projection of the auxiliary signal line on the plane of the base substrate, and the scan signal line is lapped with the auxiliary signal line.

21. The display substrate according to claim 20, wherein the forming the first conductive layer on the base substrate, and the second conductive layer disposed on the side of the first conductive layer away from the base substrate, comprises:
depositing a first conductive thin film and a second conductive thin film sequentially; and
using a patterning process with a half-tone mask to form the scan signal line and the auxiliary signal line through a first-time etching process, and to form the first electrode plate and the connection electrode through a second-time etching process.

22. The display substrate according to claim 20, wherein the storage capacitor further comprises a second electrode plate, and an orthographic projection of the second electrode plate on the plane of the base substrate is at least partially overlapped with an orthographic projection of the first electrode plate on the plane of the base substrate; the preparation method further comprises:
depositing a semiconductor thin film on a side of the second conductive layer away from the base substrate; and
using a patterning process with a half-tone mask to form the second electrode plate through an etching process and a conductorization treatment process sequentially.
